# EUROPÄISCHE PATENTSCHRIFT

(11) **EP 0 790 892 B1**
(45) Veröffentlichungstag und Bekanntmachung des Hinweises auf die Patenterteilung: **10.03.1999**
(21) Anmeldenummer: 95936587.5
(22) Anmeldetag: 03.11.1995
(51) Int. Cl.: B41F 15/36

(54) **SCHABLONENHALTER**
STENCIL HOLDER
SUPPORT POUR ECRANS DE SERIGRAPHIE

(30) Priorität: 05.11.1994 DE 4439608; 28.03.1995 DE 19511330; 18.08.1995 DE 19530373; 17.10.1995 DE 29516465 U
(43) Veröffentlichungstag der Anmeldung: 27.08.1997
(73) Patentinhaber: BEBRO-ELECTRONIC BENGEL & BROSS GmbH, D-72636 Frickenhausen (DE)
(72) Erfinder: FROMM, Alfred, D-72768 Reutlingen (DE)
(74) Vertreter: Hoeger, Stellrecht & Partner
(86) Internationale Anmeldenummer: EP9504319
(87) Internationale Veröffentlichungsnummer: WO9614210

(56) Entgegenhaltungen:
- EP-A- 0 120 651
- CA-A- 953 973
- DE-A- 3 227 434
- US-A- 3 078 793
- US-A- 3 255 540
- US-A- 3 391 635
- US-A- 3 908 293
- US-A- 4 041 861

## Beschreibung

Die Erfindung betrifft einen Schablonenhalter vorzugsweise zum Siebdruck, umfassend eine Schablone mit sich im Anschluß an einen Schablonenbereich erstreckenden Haltestreifen, welche sich maximal über die jeweilige Länge eines Randes des Schablonenbereichs in der jeweiligen Längsrichtung desselben erstrecken, einen Rahmen, an dem Rahmen angeordnete, die Haltestreifen der Schablone haltende Schablonenaufnahmen, von denen zwei einander gegenüberliegen und in einer ersten Spannrichtung ein Spannen der Schablone bewirken und zwei einander gegenüberliegen und in einer zweiten Spannrichtung ein Spannen der Schablone bewirken, wobei jeder Haltestreifen an jeweils einer einzigen Schablonenaufnahme durch Öffnungen in den Haltestreifen durchgreifende Halteelemente mit Formschluß lösbar fixierbar ist, und eine Schablonenspanneinrichtung.

Ein derartiger Schablonenhalter ist aus der CA-A-953 973 bekannt.

Die CA-A-953 973 offenbart als Schablone ein Gewebe, welches sich beim Spannen dehnt. Darüber hinaus weist dieses Gewebe verstärkte Randbereiche auf, wobei lediglich die Randverstärkungen aus einem steifen oder halbsteifen Material hergestellt sind, woraus hervorgeht, daß die Schablone selbst sich wie ein Gewebe, d. h. also elastisch verhält.

Das Spannen der Schablone ist nur möglich auf der Basis der Dehnung des Gewebes der Schablone und ergibt sich ferner aus der gesamten Konstruktion, die vorsieht, die Schablonenaufnahme, in welcher die Randbereiche des Gewebes gehalten werden, um einen festen Winkel zu drehen und in diesem festen Drehwinkel mittels des Stifts zu sichern.

Ein weiterer Schablonenhalter ist aus dem Prospekt "DEK MICROMOUNT - Fortgeschrittenes Schablonen-Spannsystem" der DEK Precision Screen Division, 11 Albany Road, Granby Industrial Estate, Weymouth, Dorset DT 4 9TH, England bekannt. Bei diesen wird beispielsweise die Schablone durch die zwei einander gegenüberliegenden Schablonenaufnahmen fixiert und in der sich zwischen den Schablonenaufnahmen erstreckenden ersten Spannrichtung gespannt.

Bei diesen bekannten Spanneinrichtungen ist allerdings die Schablone nicht gleichmäßig spannbar.

Der Erfindung liegt daher die Aufgabe zugrunde, einen Schablonenhalter der gattungsgemäßen Art derart zu verbessern, daß eine als Metallfolie ausgebildete Schablone möglichst gleichmäßig spannbar ist.

Diese Aufgabe wird bei einem Schablonenhalter der eingangs beschriebenen Art erfindungsgemäß dadurch gelöst, daß der Schablonenbereich und die Haltestreifen der Schablone aus einer einstückigen Metallfolie sind, daß die Schablonenspanneinrichtung zum Spannen der Schablone eine erste Spannkraftquelle aufweist, welche auf mindestens eine der in der ersten Spannrichtung spannenden Schablonenaufnahmen mit einer Spannkraft wirkt und diese in der ersten Spannrichtung bewegt und eine zweite Spannkraftquelle aufweist, welche auf mindestens eine der in der zweiten Spannrichtung spannenden Schablonenaufnahmen mit einer Spannkraft wirkt und diese in der zweiten Spannrichtung bewegt, und daß die Schablonenaufnahmen derart angeordnet sind, daß sie bei wirksamen Spannkräften die Schablone mit einem zwischen dem Schablonenbereich und dem Angriff der Schablonenaufnahmen liegenden Bereich gegen fest an dem Rahmen gehaltene Auflagestege ziehen.

Weitere vorteilhafte Ausgestaltungen sind Gegenstand der Unteransprüche 2 bis 29.

Der Vorteil der erfindungsgemäßen Lösung ist darin zu sehen, daß sich bei dieser die Spannkräfte optimal auf den Schablonenbereich auswirken können und nicht durch sich über den Schablonenbereich hinauserstreckende und in diesen sich darüber hinaus erstreckenden Bereichen miteinander verbundene Haltestreifen verändert, insbesondere reduziert, werden und somit ungleichmäßig auf die Schablone wirken und dabei im Extremfall zu Verwerfungen führen.

Insbesondere ist bei der erfindungsgemäßen Lösung ein weiterer großer Vorteil hinsichtlich der gleichmäßigen Spannung der Schablone darin zu sehen, daß diese in zwei quer zueinander verlaufenden Spannrichtungen spannbar ist und somit insbesondere der Schablonenbereich in zwei senkrecht zueinander verlaufenden Spannrichtungen gespannt ist, im Gegensatz zu der aus dem Stand der Technik bekannten Lösung für eine Metallfolie, bei welcher nur ein Spannen in einer Spannrichtung erfolgt.

Ferner ist es erfindungsgemäß von Vorteil, daß der Schablonenbereich und die Haltestreifen aus einer einstückigen Metallfolie sind.

Ferner hat es sich als vorteilhaft erwiesen, insbesondere um eine für ein Siebdruckverfahren geeignete stabile Position der Schablone zu erhalten, daß die Schablone zwischen einem Schablonenbereich und einem Angriff des Haltestegs durch einen Auflagesteg abgestützt ist, wobei die Schablonenaufnahmen die Schablone beim Spannen gegen den Auflagesteg ziehen.

Zweckmäßigerweise ist bei der erfindungsgemäßen Lösung die Schablone so ausgebildet, daß diese einen rechteckförmigen Schablonenbereich und insgesamt vier jeweils paarweise einander gegenüberliegende Haltestreifen aufweist, wobei jedes Paar von Haltestreifen in einer Spannrichtung spannbar ist.

Prinzipiell wäre es möglich, jeden Haltestreifen an mehreren Schablonenaufnahmen zu fixieren. Besonders vorteilhaft ist es jedoch, wenn jeder Haltestreifen, insbesondere als Ganzes, an einer einzigen Schablonenaufnahme lösbar fixierbar ist, so daß jede Schablonenaufnahme als Ganzes die Spannkraft auf den gesamten Haltestreifen aufbringt.

Zur lösbaren Fixierung der Haltestreifen an den Schablonenaufnahmen ist vorzugsweise vorgesehen, daß jeder Haltestreifen durch Formschluß an der jeweiligen Schablonenaufnahme lösbar fixierbar ist. Ein Formschluß bildet im Gegensatz zu einem Reibschluß eine weit einfachere, und für die Aufnahme einer Spannkraft geeignetere Lösung als ein Reibschluß.

Im einfachsten Fall ist dabei vorgesehen, daß jeder Haltestreifen durch eine Reihe von Formschlußelementen an der jeweiligen Schablonenaufnahme lösbar fixierbar ist, wobei vorzugsweise die Formschlußelemente in der Reihe in im wesentlichen gleichmäßigen Abständen aufeinanderfolgend angeordnet sind.

Hinsichtlich der Fixierung der Schablone in der jeweiligen Schablonenaufnahme wurden bislang keine näheren Angaben gemacht. So wäre beispielsweise eine kraftschlüssige Klemmung denkbar. Besonders zweckmäßig hat es sich jedoch erwiesen, wenn die Fixierung der Schablone in der Schablonenaufnahme durch ein Formschluß erfolgt, da über eine formschlüssige Verbindung weit besser die Spannkräfte auf die Schablone übertragbar sind.

Eine derartige formschlüssige Verbindung kann durch alle Arten von Formschlußelementen, die zwischen der Schablonenaufnahme und dem Haltesteg wirksam sind, erfolgen. Derartige Formschlußelemente umfassen im einfachsten Fall Öffnungen in den Haltestreifen und die Öffnungen durchgreifende Halteelemente.

Bei auswechselbaren Schablonen hat es sich als besonders vorteilhaft erwiesen, wenn die Schablonenaufnahme eine quer zur Spannrichtung wirksame Positioniereinrichtung aufweist. Mit dieser Positioniereinrichtung ist es möglich, die Schablone quer zur Spannrichtung exakt zu positionieren und damit bei einem Einwechseln einer Schablone automatisch deren exakte Position quer zur Spannrichtung zu erreichen.

Besonders zweckmäßig ist dies bei einer erfindungsgemäßen Spanneinrichtung, bei welcher die Schablone in zwei senkrecht zueinander verlaufende Spanneinrichtungen spannbar ist, da mit einer derartigen Positioniereinrichtung dann automatisch eine exakte Festlegung des Orts der Schablone in der durch die Schablone gebildeten Ebene möglich ist.

Eine derartige Positioniereinrichtung kann in unterschiedlichster Art und Weise ausgebildet sein. So könnte eine derartige Positioniereinrichtung durch optische Marken gebildet sein. Besonders einfach und sicher ist jedoch die Positionierung der Schablone mit einer Positioniereinrichtung, wenn diese eine Fassung umfaßt.

Die Passung kann dabei in unterschiedlichster Art und Weise ausgebildet sein; sie kann durch zwei beabstandete Passflächen gebildet sein, zwischen welche ein Abschnitt der Schablone einlegbar ist.

Besonders zweckmäßig ist es jedoch, wenn die Passung durch eine Lochreihe gebildet ist, in welche entsprechende Passfinger eingreifen.

Ein besonders vorteilhaftes Ausführungsbeispiel sieht dabei vor, daß die Öffnungen und die diese durchgreifenden Halteelemente gleichzeitig als Fassungen zur exakten Positionierung der Schablone in der Schablonenaufnahme ausgebildet sind.

Hinsichtlich der Ausbildung der Schablonenaufnahmen wurden im Zusammenhang mit der bisherigen Erläuterung der einzelnen Ausführungsbeispiele keine näheren Angaben gemacht. So sieht ein vorteilhaftes Ausführungsbeispiel vor, daß in jeder Spannrichtung zwei einander gegenüberliegende Haltestege, welche am Rahmen gelagert sind, die Schablonenaufnahmen bilden, wobei an jedem Haltesteg jeweils ein Haltestreifen fixierbar ist.

Vorzugsweise ist dabei jeder Haltesteg so ausgebildet, daß er Öffnungen im Haltestreifen durchgreifende Halteelemente aufweist, wobei vorzugsweise die Öffnungen in Form einer Lochreihe am Haltestreifen angeordnet sind.

Um den jeweiligen Haltestreifen an dem jeweiligen Haltesteg so zu fixieren, daß die Halteelemente in Eingriff mit den Öffnungen im jeweiligen Haltestreifen bleiben, ist vorzugsweise vorgesehen, daß in einer am jeweiligen Haltesteg fixierten Stellung jeder Haltestreifen mit einem Niederhalter auf einer Fixierauflagefläche des jeweiligen Haltestegs aufliegend gehalten ist. Dadurch wird erreicht, daß der Haltestreifen nicht von der Fixierauflagefläche des jeweiligen Haltestegs abhebt und somit auch die Halteelemente mit den Öffnungen außer Eingriff kommen.

Besonders zweckmäßig ist es dabei, wenn der Niederhalter in der fixierenden Stellung den jeweiligen Haltestreifen in Bereichen zwischen den als Fixierzapfen ausgebildeten Halteelementen mit Fingern übergreift, um auch ein Aufwerfen der Metallfolie der Haltestreifen in den Bereichen zwischen den Fixierzapfen beim Spannen zu verhindern, da ein derartiges Aufwerfen ebenfalls zur Faltenbildung in der Schablone führen würde.

Besonders vorteilhaft läßt sich ein Anlegen der Schablone an den Auflagestegen dadurch erreichen, daß die Schablonenaufnahmen auf einer der Schablone gegenüberliegenden Seite einer durch die Auflagestege definierten Ebene angeordnet und bewegbar sind. Dies hat auch noch den weiteren Vorteil, daß die Schablonenaufnahmen auch die Bewegung einer auf der Schablone arbeitenden Rakel nicht stören.

Hinsichtlich der Anordnung der Auflagestege am Schablonenhalter wurden im Zusammenhang mit der bisherigen Erläuterung der einzelnen Ausführungsbeispiele keine näheren Angaben gemacht.

So sieht ein besonders vorteilhaftes Ausführungsbeispiel vor, daß der Schablonenhalter einen aus Rahmenträgern gebildeten äußeren Rahmen aufweist, in welchem ein Schablonenfeld angeordnet ist und daß das Schablonenfeld durch vier Auflagestege begrenzt ist, welche über Streben mit dem Rahmen verbunden sind. Bei dieser Lösung ist somit durch den äußeren Rahmen die Möglichkeit geschaffen, den Schablonenhalter in einer mit der Schablone arbeitenden Maschine exakt an seinem äußeren Umfang zu führen und zu positionieren und außerdem ist die Schablone durch die das Schablonenfeld bildenden Auflagestege, die fest mit dem äußeren Rahmen verbunden sind, ebenfalls exakt relativ zum äußeren Rahmen positioniert.

Die Positionierung der Schablone mittels der Auflagestege läßt sich besonders einfach dadurch realisieren, daß jeder der Auflagestege eine Auflagefläche aufweist, auf welche die Haltestreifen der Schablone auflegbar sind. Das heißt bei diesem Ausführungsbeispiel liegt die Schablone mit den Haltestreifen auf den Auflageflächen der Auflagestege aus, so daß insbesondere der Schablonenbereich innerhalb des durch die Auflagestege definierten Schablonenfeldes liegt, was insbesondere für ein faltenfreies und vorzugsweise gleichmäßiges Spannen der Schablone von großem Vorteil ist.

Um die Haltestreifen in einfacher Weise mit den Haltestegen verbinden zu können, ist vorzugsweise vorgesehen, daß sich jeder Haltestreifen über den jeweiligen Auflagesteg hinaus bis zu dem jeweiligen Haltesteg erstreckt, so daß somit die Haltestege außerhalb des durch die Auflagestege begrenzten Schablonenfeldes an den Haltestreifen angreifen können.

Hinsichtlich der Bewegbarkeit der Haltestege in den jeweiligen Spannrichtungen wurden im Zusammenhang mit der bisherigen Beschreibung der erfindungsgemäßen Lösung keine näheren Angaben gemacht. So sieht ein vorteilhaftes Ausführungsbeispiel vor, daß von zwei in einer Spannrichtung wirksamen Haltestegen mindestens einer in Richtung der jeweiligen Spannrichtung mittels der Schablonenspanneinrichtung bewegbar ist. Der andere Haltesteg kann beispielsweise in der Spannrichtung unbewegbar am Rahmen gehalten sein.

Hinsichtlich der Anordnung der jeweils in der Spannrichtung bewegbaren Haltestege wurden bislang keine näheren Angaben gemacht. So wäre es beispielsweise zweckmäßig, wenn die Haltestege durch jede Art von Verschiebeführung geführt sind.

Als besonders vorteilhaft hat es sich erwiesen, wenn die Haltestege an einer in der jeweiligen Spannrichtung wirksamen Parallelführung gelagert sind. Diese Parallelführung könnte beispielsweise als Hebelführung ausgebildet sein. Besonders vorteilhaft ist es jedoch, wenn die parallelführung zwei zueinander parallele Längsführungen umfaßt.

Die Längsführungen sind zweckmäßigerweise als Führungsstäbe ausgebildet, auf welchen Führungsbüchsen gleiten.

Alternativ zu Führungsstäben mit Führungsbüchsen als Längsführungen, welche beispielsweise die Haltestege innerhalb von deren Längserstreckung führen, sieht eine Lösung hierzu vor, daß die Haltestege endseitig an Längsführungen geführt sind.

Vorzugsweise sind zwischen den beiden Enden jedes Haltestegs und den mit dem Rahmen verbundenen Streben Längsführungen vorgesehen, welche insbesondere die Möglichkeit bieten, den jeweiligen Haltesteg in Richtung seiner Längserstreckung und somit quer zur jeweiligen Spannrichtung exakt zu führen.

Zweckmäßigerweise ist jede derartige Längsführung durch in einer Führungsnut verlaufende Wälzkörper gebildet, wobei vorzugsweise die Führungsnut in der jeweiligen endseitig des Stegs verlaufenden Strebe angeordnet ist und beispielsweise die Wälzkörper an dem Haltesteg gehalten sind.

Alle Verschiebeführungen können so ausgebildet sein, daß sie eine Bewegung in der jeweiligen Spannrichtung mit Spiel quer dazu zulassen. Soll jedoch die Bewegung des jeweiligen Haltestegs ausschließlich auf die Spannrichtung begrenzt sein, so ist vorzugsweise die jeweilige Verschiebeführung mit möglichst geringem Spiel behaftet.

Hinsichtlich der Ausbildung der Schablonenspanneinrichtung wurden im Zusammenhang mit der bisherigen Beschreibung ebenfalls keine näheren Angaben gemacht.

So sind bei einer vorteilhaften Variante der Erfindung die Schablonenspanneinrichtungen durch in der jeweiligen Spannrichtung wirksame hydraulische oder pneumatische Spannelemente gebildet, welche jeweils derart miteinander gekoppelt sind, daß auf die Haltestege gleichzeitig dieselben Kräfte wirken.

Im einfachsten Fall umfaßt die Spanneinrichtung bei dieser Lösung mindestens einen zwischen dem jeweiligen Haltesteg und dem Rahmen wirkenden Spannzylinder, mit welchem der jeweilige Haltesteg zum Spannen der Schablonen bewegbar ist.

Um eine Gleichwirkung aller Spannzylinder zu erreichen und in jeder Spannrichtung gleichzeitig mit derselben Spannkraft zu spannen, ist vorzugsweise vorgesehen, daß die Spannzylinder parallel geschaltet und mit einer Druckleitung verbunden sind, so daß sich in jedem Spannzylinder derselbe Druck aufbaut und somit bei identischen Spannzylindern jeder Spannzylinder dieselbe Spannkraft erzeugt.

Prinzipiell würde ein Spannzylinder pro Haltesteg ausreichen. Um eine möglichst gleichmäßige Krafteinwirkung auf jeden Haltesteg zu erhalten, sind jedoch vorteilhafterweise zwischen dem jeweiligen Haltesteg und dem Rahmen jeweils zwei im Abstand voneinander angeordnete und parallel wirkende Spannzylinder vorgesehen.

Ein vorteilhaftes Ausführungsbeispiel der Spanneinrichtung sieht als Alternative zu den vorstehend genannten Möglichkeiten einen Spannzug vor, welcher auf die jeweils zwei einander gegenüberliegenden und in derselben Spannrichtung beweglichen Haltestege gleichzeitig wirkt und durch ein Spannelement spannbar ist. Zweckmäßigerweise ist der Spannzug ein unelastischer Zug.

Vorzugsweise weist der Spannzug jeweils eine zwischen den Rahmen und dem jeweiligen Haltesteg wirksame Schleife auf, deren Größe je nach Zugeinwirkung auf den Spannzug variierbar ist. Insbesondere ist dabei der Spannzug jeweils über Rollen zur Bildung der Schleife umgelenkt, um jegliches Klemmen und somit das Auftreten ungleicher Kräfte auf die Haltestege zu vermeiden.

Ein besonders vorteilhaftes Ausführungsbeispiel, bei welchem ein Spannen der Schablone in zwei Spannrichtungen möglich ist, sieht vor, daß der Spannzug zum Spannen aller vier Haltestege dient.

In diesem Fall erfolgt eine Umlenkung des Spannzuges über Umlenkrollen in Eckbereichen des Schablonenhalters.

Ein derartiger Spannzug hat prinzipiell den Vorteil, daß er sich über ein mechanisches Spannelement, beispielsweise ein Hebelelement oder eine Spannhülse, mit einem Spannbolzen durch Zug spannen läßt und diese Zugkraft lange Zeit beständig bestehen bleibt, so daß insbesondere in einem Fall, in welchem die Schablone lange Zeit mit denselben Spannkräften gespannt werden soll, ein derartiger Spannzug gegenüber hydraulischen oder pneumatischen Lösungen aufgrund seiner Einfachheit von Vorteil ist.

Ferner hat ein derartiger Spannzug den weiteren Vorteil, daß er sich in einfacher Weise in jede gewünschte Richtung durch die Umlenkrollen führen läßt.

Hinsichtlich des Kraftangriffs der Spanneinrichtung an den Haltestegen wurden bislang keine speziellen Angaben gemacht. So wäre es beispielsweise möglich, unter Verwendung eines Spannzuges an zwei beabstandeten Stellen auf den Haltesteg einzuwirken.

Besonders vorteilhaft, insbesondere um eine leichte Bewegbarkeit des Haltesteges und ein Klemmen desselben sicherzustellen ist es jedoch, wenn die Schablonenspanneinrichtung mittig der Haltestege angreift und vorzugsweise die Haltestege beiderseits des mittigen Kraftangriffs geführt sind.

Hinsichtlich der Art und Weise, die Schablone in den zwei quer zueinander verlaufenden Spannrichtungen zu spannen, sind die unterschiedlichsten Lösungen denkbar. So sieht eine vorteilhafte Lösung vor, daß die Schablonenaufnahmen zwei einander gegenüberliegende Haltestege aufweisen, die an dem Rahmen ausschließlich in Richtung der ersten Spannrichtung verschieblich geführt sind, daß die Schablonenspanneinrichtung eine auf beide Haltestege gleichzeitig mit derselben Spannkraft wirkende Spannkraftquelle aufweist, daß die Schablonenaufnahmen zwei einander gegenüberliegende Haltestege aufweisen, die am Rahmen ausschließlich in Richtung der zweiten Spannrichtung verschieblich geführt sind und daß die Schablonenspanneinrichtung eine auf die beiden Haltestege gleichzeitig mit derselben Spannkraft wirkende Spannkraftquelle aufweist.

Bei dieser Lösung ist der Vorteil darin zu sehen, daß beim Spannen durch die exakte Führung der beiden Haltestege ausschließlich in der ersten Spannrichtung und in der zweiten Spannrichtung eine definierte Position der in den Schablonenaufnahmen fixierten Schablonen in Richtung quer zu der jeweiligen Spannrichtung gegeben ist und daß andererseits auch durch das gleichzeitige Aufbringen derselben Spannkraft auf jeden der Haltestege ein gleichmäßiges Spannen der Schablone in der ersten Spannrichtung dadurch erfolgt, so daß sich die beiden Haltestege unter Einwirkung jeweils derselben Spannkraft voneinander weg bewegen.

Dabei ist vorzugsweise die Schablone durch die zwei quer zueinander verlaufenden Spannrichtungen und die ausschließliche Führung der Haltestege in diesen Spannrichtungen mit ihrer Position relativ zum Rahmen fixiert. So erfolgt durch die zweite Spannrichtung gleichzeitig eine Fixierung der Schablone in der ersten Spannrichtung und durch die erste Spannrichtung eine Fixierung der Schablone in der zweiten Spannrichtung, so daß bei einer derartigen Ausbildung der erfindungsgemäßen Lösung die an den Schablonenaufnahme fixierte Schablone zwangsläufig exakt in den beiden Spannrichtungen positionierbar ist.

Eine besonders vorteilhafte Ausführungsform dieser Lösung sieht vor, daß eine einzige Spannkraftquelle auf alle Haltestege wirkt.

Alternativ zu dieser Lösung sieht eine andere Ausführungsform der erfindungsgemäßen Lösung vor, daß von zwei in der ersten Spannrichtung wirksamen Haltestegen einer der Haltestege fest mit dem Rahmen verbunden ist und der dem festen Haltesteg gegenüberliegende Haltesteg in der ersten Spannrichtung gegenüber dem Rahmen bewegbar ist und daß die in der zweiten Spannrichtung wirksamen Haltestege in der ersten Spannrichtung gegenüber dem Rahmen bewegbar sind und mindestens einer der in der zweiten Spannrichtung wirksamen Haltestege in der zweiten Spannrichtung gegenüber dem Rahmen bewegbar ist. Diese Lösung geht davon aus, daß die Schablone durch den fest mit dem Rahmen verbundenen Haltesteg ausreichend positionierbar ist, wobei in diesem Fall eine Bewegbarkeit der in der zweiten Spannrichtung wirksamen Haltestege in der ersten Spannrichtung erforderlich ist, um einen Faltenwurf zu vermeiden, wobei diese Bewegbarkeit durch ein Führungsspiel realisierbar ist.

Besonders vorteilhaft ist es bei diesem Ausführungsbeispiel, wenn der in der ersten Spannrichtung wirksame und in dieser bewegbare Haltesteg auch in der zweiten Spannrichtung gegenüber dem Rahmen bewegbar ist, um auch hier einen Ausgleich gegenüber einem Faltenwurf vorzusehen, wobei auch die Bewegbarkeit in der zweiten Spannrichtung durch ein Führungsspiel realisierbar ist.

Ein weiteres Ausführungsbeispiel einer erfindungsgemäßen Lösung sieht vor, daß von zwei in der ersten Spannrichtung wirksamen Haltestegen mindestens einer der Haltestege in der ersten Spannrichtung gegenüber dem Rahmen bewegbar gelagert ist, daß beide in der ersten Spannrichtung wirksamen Haltestege in der zweiten Spannrichtung verschieblich gelagert sind und daß die in der zweiten Spannrichtung wirksamen Haltestege in der ersten Spannrichtung gegenüber dem Rahmen bewegbar sind und mindestens einer der in der zweiten Spannrichtung wirksamen Haltestege in der zweiten Spannrichtung gegenüber dem Rahmen bewegbar ist.

Bei beiden vorstehend beschriebenen Ausführungsbeispielen ist es denkbar, einem der in der zweiten Spannrichtung wirksamen Haltestege in der zweiten Spannrichtung unverschieblich anzuordnen und nur den anderen Haltesteg bewegbar. Besonders günstig ist es, wenn beide in der zweiten Spannrichtung wirksamen Haltestege in dieser bewegbar gegenüber dem Rahmen gelagert sind, so daß durch diese ein symmetrisches Spannen in der zweiten Richtung realisierbar ist.

Im Zusammenhang mit der Lösung, daß von den in der ersten Spannrichtung wirksamen Haltestegen mindestens einer der Haltestege in der ersten Spannrichtung gegenüber dem Rahmen bewegbar ist, ist es bei einer vorteilhaften Lösung vorgesehen, daß einer der Haltestege in der ersten Spannrichtung unverschieblich an dem Rahmen gelagert ist, um damit in der ersten Spannrichtung eine feste Position für die Schablone vorzugeben.

Allerdings ist es aber auch möglich, daß beide in der ersten Spannrichtung wirksamen Haltestege in diese gegenüber dem Rahmen bewegbar gelagert sind, wobei in diesem Fall eine Erfassung der Position der Schablone vorzugsweise über eine Markierung auf der Schablone vorgesehen sein kann.

Weitere Merkmale und Vorteile der Erfindung sind Gegenstand der nachfolgenden Beschreibung sowie der zeichnerischen Darstellung eines Ausführungsbeispiels.

In der Zeichnung zeigen:
- Fig. 1: eine Draufsicht auf ein erstes Ausführungsbeispiel eines erfindungsgemäßen Schablonenhalters;
- Fig. 2: eine vergrößerte Teilansicht einer Längsseite des Schablonenhalters;
- Fig. 3: einen Schnitt längs Linie 3-3 in Fig. 2;
- Fig. 4: eine vergrößerte Schnittdarstellung längs Linie 4-4 in Fig. 2 bei die Schablone festhaltender Schablonenaufnahme;
- Fig. 5: eine Darstellung ähnlich Fig. 4 bei geöffneter Schablonenaufnahme;
- Fig. 6: eine Draufsicht auf eine Schablone für den Schablonenhalter;
- Fig. 7: einen vergrößerten Schnitt durch ein Spannelement des Schablonenhalters.
- Fig. 8: eine Draufsicht ähnlich Fig. 1 auf ein zweites Ausführungsbeispiel eines erfindungsgemäßen Schablonenhalters;
- Fig. 9: eine vergrößerte Teilansicht ähnlich Fig. 2 des zweiten Ausführungsbeispiels;

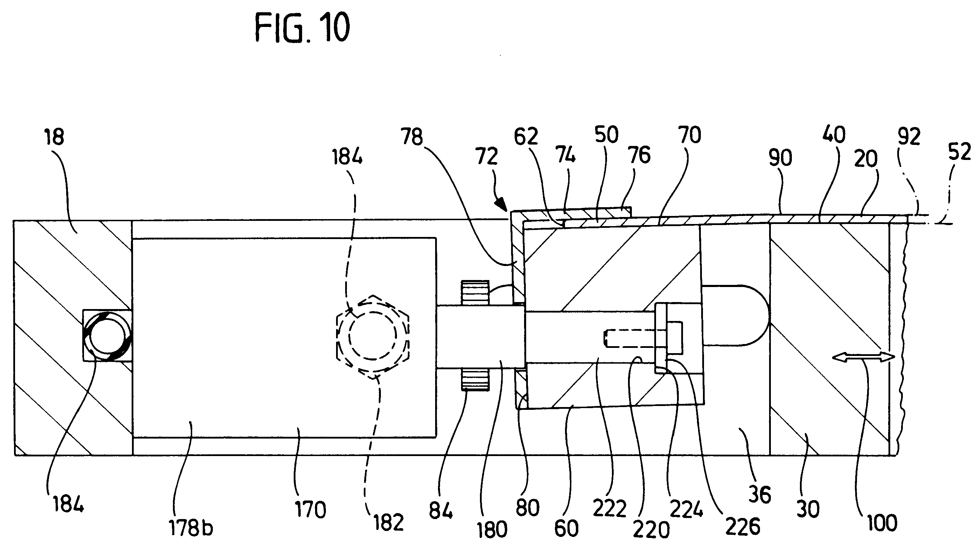

- Fig. 10: einen Schnitt längs Linie 10-10 in Fig. 9;
- Fig. 11: einen Schnitt Linie 11-11 in Fig. 9;
- Fig. 12: eine Draufsicht ähnlich Fig. 8 auf ein drittes Ausführungsbeispiel eines erfindungsgemäßen Schablonenhalters und
- Fig. 13: eine Draufsicht ähnlich Fig. 8 auf ein viertes Ausführungsbeispiel eines erfindungsgemäßen Schablonenhalters.

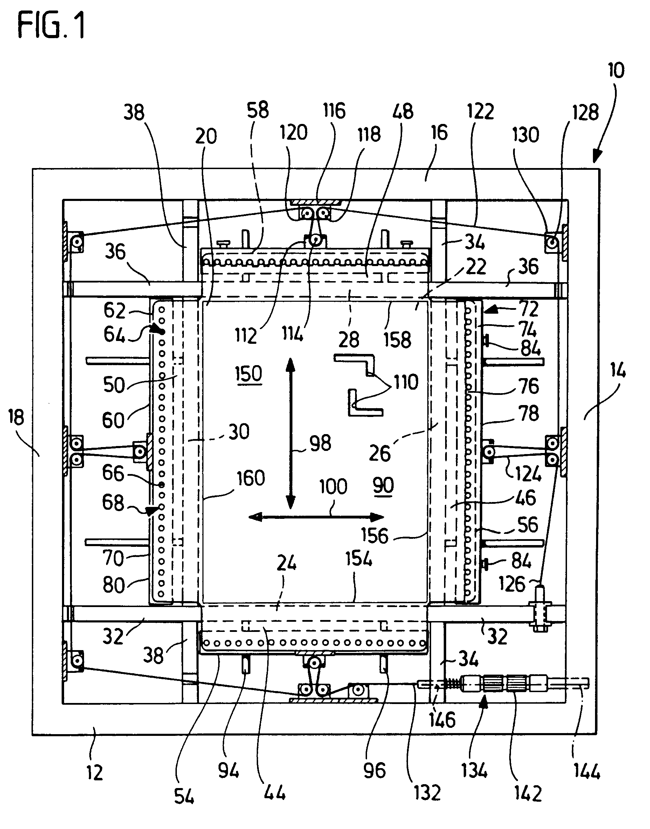

Ein erstes Ausführungsbeispiel eines erfindungsgemäßen Schablonenhalters, dargestellt in Fig. 1, umfaßt einen als Ganzes mit 10 bezeichneten Rahmen, welcher durch vier Längsseiten des Rahmens bildende Rahmenträger 12, 14, 16 und 18 gebildet ist. Der Rahmen 10 ist im Bereich der Rahmenträger 12 bis 18 beispielsweise in einer Siebdruckanlage aufnehmbar und exakt positionierbar, um eine als Ganzes mit 20 bezeichnete Schablone zum Siebdrucken exakt zu positionieren.

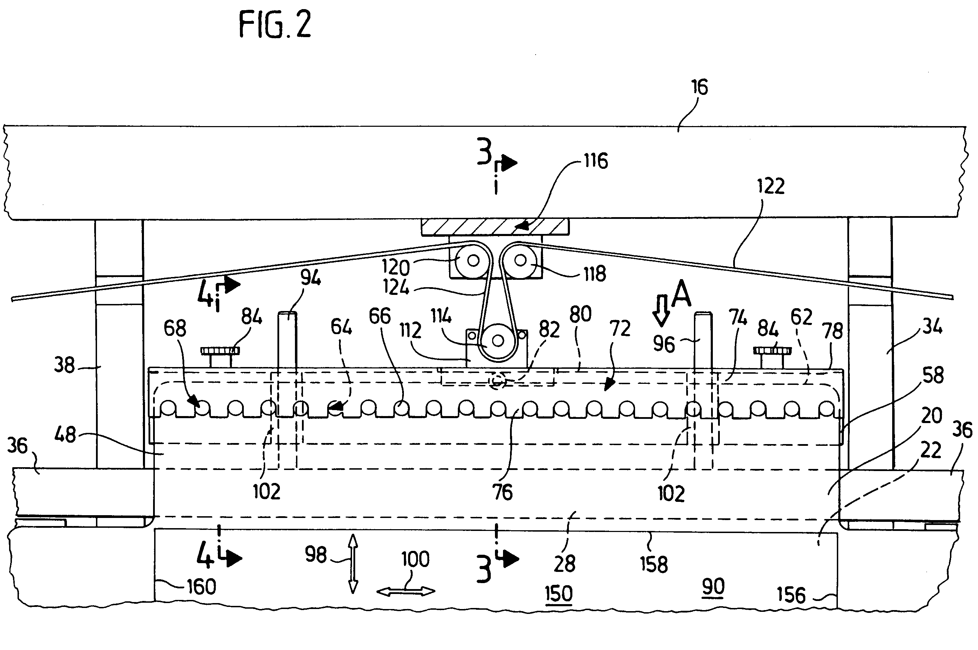

Die Schablone 20 liegt in einem Schablonenfeld 22 des Rahmens 10, welches durch vier Auflagestege 24, 26, 28 und 30 begrenzt ist. Die Auflagestege 24 bis 30 sind ihrerseits über in Fortsetzung derselben bis zu den Rahmenträgern 12 bis 18 verlaufende Streben 32, 34, 36, 38 mit diesen verbunden (Fig. 1 und 2).

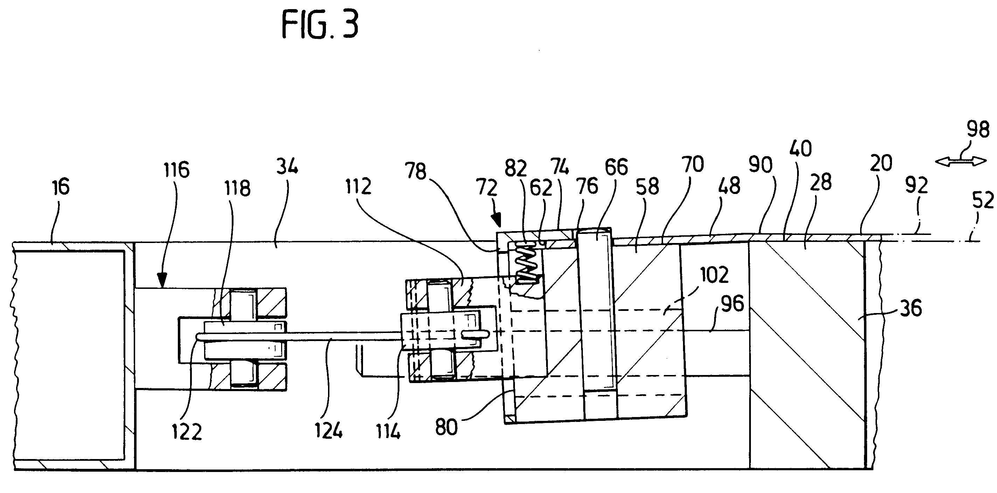

Wie exemplarisch im Fall des Auflagestegs 30 in Fig. 2 und 3 dargestellt, umfaßt jeder der Auflagestege 24 bis 30 eine Auflagefläche 40, auf welcher seitliche Haltestreifen 44, 46, 48 und 50 der Schablone 20 auflegbar sind, um die Schablone 20 auf einer definierten Ebene 52 zu positionieren, wobei die Ebene 52 durch die Auflageflächen 40 der Auflagestege 24, 26, 28 und 30 festgelegt ist.

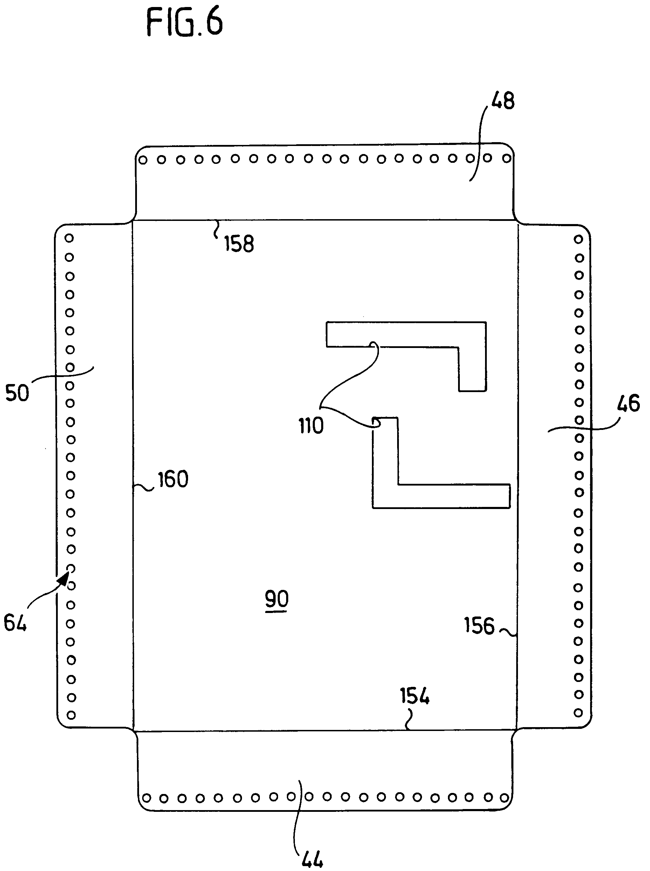

Jeder der Haltestreifen 44 bis 50 (Fig. 6) erstreckt sich ferner über den jeweiligen Auflagesteg 24 bis 30 hinaus bis zu jeweils einem Haltesteg 54, 56, 58, 60 an welchem der Haltestreifen 44 fixierbar ist.

Hierzu weist der jeweilige Haltestreifen 44 bis 50 eine entlang einer äußeren Seitenkante 62 verlaufende Lochreihe 64 (Fig. 6) auf, durch welche Fixierzapfen 66 einer am jeweiligen Haltesteg 54 bis 60 angeordneten Fixierzapfenreihe 68 hindurchgreifen (Fig. 3, 4, 5). Seitlich der Lochreihen 64 liegt dabei der jeweilige Haltestreifen 44 bis 50 auf einer Fixierauflagefläche 70 des jeweiligen Haltestegs 54 bis 60 auf und wird mittels eines Niederhalters 72 auf der Fixierauflagefläche 70 aufliegend gehalten, wobei die Fixierzapfen 66 aus der Fixierauflagefläche 70 hervorstehen und die jeweilige Lochreihe 64 des auf dieser Fixierauflagefläche 70 aufliegenden Haltestreifens 44 bis 50 durchgreifen.

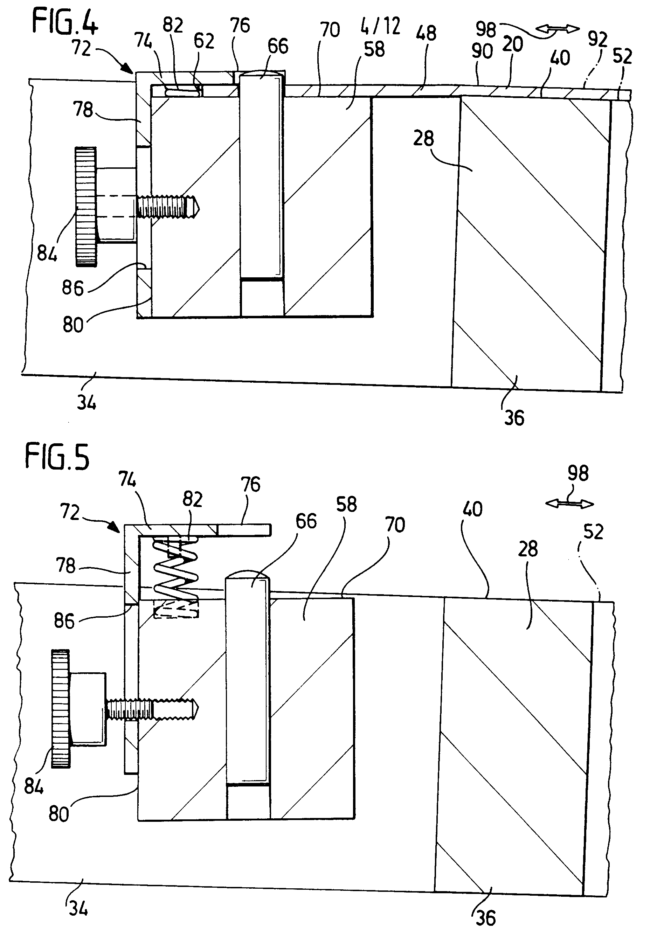

Der Niederhalter 72 weist vorzugsweise eine Auflageleiste 74 auf, welche sich parallel zur Fixierauflagefläche 70 erstreckt und, wie in Fig. 2 dargestellt, den jeweiligen Haltestreifen 44 bis 60 in seinen Bereichen zwischen den Fixierzapfen 66 mit Fingern 76 übergreift. Ferner umfaßt der Niederhalter 72 einen Führungsschenkel 78, welcher auf einer dem jeweiligen Auflagesteg 24 bis 30 abgewandten Seite 80 des jeweiligen Haltestegs 54 bis 60 anliegt und quer, vorzugsweise senkrecht zur Fixierauflagefläche 70 relativ zum jeweiligen Haltesteg 54 bis 60 bewegbar ist, um die Auflageleiste 74 auf die Fixierauflagefläche 70 zu- oder von dieser wegzubewegen (Fig. 4, 5). Vorzugsweise ist der Niederhalter 72 durch eine auf die Auflageleiste 74 wirkende Druckfeder 82 in Richtung einer den jeweiligen Haltestreifen 44 bis 50 freigebenden Stellung der Auflageleiste 74 beaufschlagt (Fig. 5) und gegen die Kraft der Druckfeder 82 in eine den jeweiligen Haltestreifen 44 bis 50 an der Fixierauflagefläche 70 anliegende Stellung (Fig. 4) bewegbar und in dieser durch Klemmschrauben 84 festlegbar, wobei die Klemmschrauben 84 Langlöcher 86 im Führungsschenkel 78 durchgreifen und somit zusammen mit den Langlöchern 86 als Führung für die Führungsschenkel 78 an dem jeweiligen Haltesteg 54 bis 60 dienen.

Sowohl die Haltestege 54 bis 60 mit den jeweiligen Niederhaltern 72 als auch die Fixierzapfen 66 sind so angeordnet, daß sie in der die Haltestreifen 44 bis 50 fixierenden Stellung unterhalb einer durch eine Oberseite 90 der Schablone 20 im Bereich des Schablonenfeldes 22 definierten Ebene 92 liegen, so daß eine über die Oberseite 90 laufende Rakel sich sowohl über den Niederhalter 72 als auch die Fixierzapfen 66 kollisionsfrei hinwegbewegen kann.

Jeder der Haltestege 54 bis 60 ist durch eine Parallelführung, gebildet durch zwei zur jeweiligen Spannrichtung 98, 100 parallele Führungsstäbe 94 und 96, in nur einer Spannrichtung 98 oder 100 beweglich geführt, wobei die Spannrichtungen 98 und 100 parallel zur Ebene 92 verlaufen und außerdem senkrecht aufeinander stehen. Dabei sind die Haltestege 54 und 58 ausschließlich in der Spannrichtung 98 und die Haltestege 56 und 60 ausschließlich in der Spannrichtung 100 bewegbar.

Dabei sind beispielsweise die Führungsstäbe 94 und 96 an den Auflagestegen 24 bis 30 gehalten, sie können aber genauso zusätzlich oder alternativ an den Rahmenträgern 12 bis 18 gehalten sein.

Um ein leichtes Gleiten der Haltestege 54 bis 60 an den Führungsstäben 94 und 96 zu ermöglichen, sind die Haltestege über Führungsbüchsen 102, vorzugsweise ausgeführt als Kugelbüchsen, an den als Rundstäben ausgebildeten Führungsstäben 94 und 96 exakt und leicht gleitend geführt. Durch die genau definierte Verschiebbarkeit der einander gegenüberliegenden Haltestege 54 und 58 in der Spannrichtung 98 und der einander gegenüberliegenden Haltestege 56 und 60 in der Spannrichtung 100 ist bei einer in Form einer Fassung ausgebildeten Lochreihe 64 und Fixierzapfen 68 die Schablone 20 in der Ebene 92 exakt positioniert, so daß in dieser vorgesehene Durchbrüche 110 beim Einlegen der Schablone 20 mit den Lochreihen 64 in die jeweiligen Fixierzapfenreihen 68 in der Ebene 92 definiert positioniert sind.

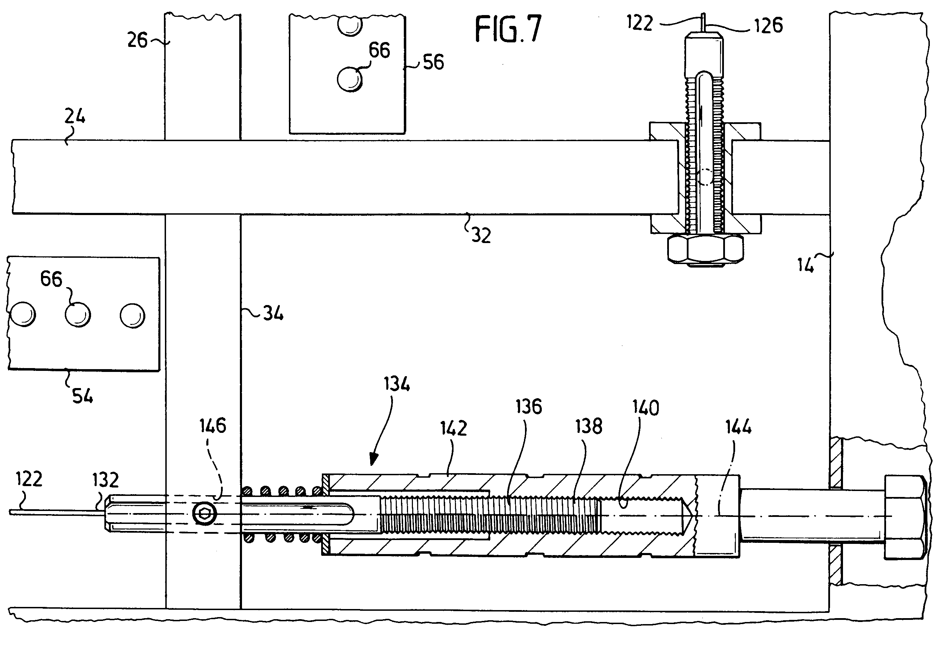

Zum Spannen der Schablone 20 sind die jeweils einander gegenüberliegenden Haltestege 54 und 58 sowie 56 und 60 jeweils in den entsprechenden Spannrichtung 98 bzw. 100 mittels einer gemeinsamen Schablonenspanneinrichtung bewegbar, welche einen an jedem der Haltestege 54 bis 60 angeordneten Lagerblock 112 und eine drehbar am jeweiligen Lagerblock 112 angeordnete Spannrolle 114 umfaßt, sowie den Lagerblöcken 112 gegenüberliegend an den Rahmenträgern 12, 14, 16 und 18 angeordnete Umlenkblöcke 116 mit zwei Umlenkrollen 118 und 120, zwischen denen ein im einfachsten Fall durch ein Stahlseil gebildeter Spannzug 122 in Form einer Schleife 124 hervortritt und die Spannrolle 114 umschlingt. Der Spannzug 122 erstreckt sich dabei ausgehend von einem fixierten Ende 126, jeweils umgelenkt noch durch Eckumlenkrollen 128, gelagert in Eckumlenkblöcken 130, von einem Umlenkblock 116 zum nächsten, wobei im Bereich jedes Umlenkblocks 116 die zum jeweiligen Haltesteg 54 bis 60 führende Schleife 124 gebildet wird. An seinem dem Ende 126 entgegengesetzten Ende 132 des Spannzugs 122 wird dieser mittels eines in Fig. 7 dargestellten Spannelements 134 gespannt, welches einen mit dem Ende 132 fest verbundenen Spannbolzen 136 aufweist, welcher ein Außengewinde 138 aufweist, das seinerseits in ein Innengewinde 140 einer Spannhülse 142 eingreift, die ihrerseits drehbar am Rahmen 10, beispielsweise am Rahmenträger 14 drehbar gelagert ist (Fig. 7).

Ferner ist der Spannbolzen 136 unverdrehbar, jedoch in Richtung seiner Längsachse 144 verschieblich am Rahmen 10 geführt, vorzugsweise in einem Durchbruch 146 durch die Strebe 34, so daß er durch Drehen der Spannhülse 42 der Spannbolzen 136 in Richtung seiner Längsachse 144 verschiebbar ist, um den Spannzug 122 zu spannen und somit über jede der Schleifen 124 die in der jeweiligen Spannrichtung 98 bzw. 100 wirkenden Spannkraft zu erzeugen und damit die Schablone 20 in den Spannrichtungen 98 und 100 gleichzeitig zu spannen, wobei hierdurch die Haltestreifen 44 bis 50 auf den Auflageflächen 40 der Auflagestege 24 bis 30 zur Anlage kommen und somit die Schablone 20 exakt auf der durch die Auflageflächen 40 der Auflagestege 24 bis 30 definierten Ebene 52 aufliegt, so daß zusätzlich zur exakten Positionierung der Schablone 20 in den Spannrichtungen 98 und 100 eine exakte Positionierung senkrecht zu diesen Spannrichtungen 98 und 100 erreichbar ist.

Die Schablone ist vorzugsweise so ausgebildet, daß sie einen mittleren Schablonenbereich 150 aufweist, in welchem die für den Siebdruck erforderlichen Durchbrüche 110 angeordnet sind, und daran an einen Rand des Schablonenbereichs 150 bildenden Seitenkanten 154, 156, 158 und 160 des Schablonenbereichs 150 anschließend die Haltestreifen 44, 46, 48 und 50, die sich jeweils maximal über die Länge der jeweils entsprechenden Seitenkanten 154, 156, 158, 160 erstrecken, so daß die Schablone 20 Eckausschnitte aufweist und dadurch die Spannwirkung in der einen Spannrichtung 98 und die Spannwirkung in der jeweils anderen Spannrichtung 100 durch die Haltestreifen 44 bis 50 nicht reduziert ist, sondern sich voll über die jeweilige Ausdehnung des Schablonenbereichs 150 in der jeweiligen Spannrichtung 98, 100 entfalten kann (Fig. 6).

Bei einem zweiten Ausführungsbeispiel eines erfindungsgemäßen Schablonenhalters sind diejenigen Teile, die mit denen des ersten Ausführungsbeispiels identisch sind, mit denselben Bezugszeichen versehen, so daß hinsichtlich der Beschreibung derselben auf die Ausführungen zum ersten Ausführungsbeispiel voll inhaltlich Bezug genommen werden kann.

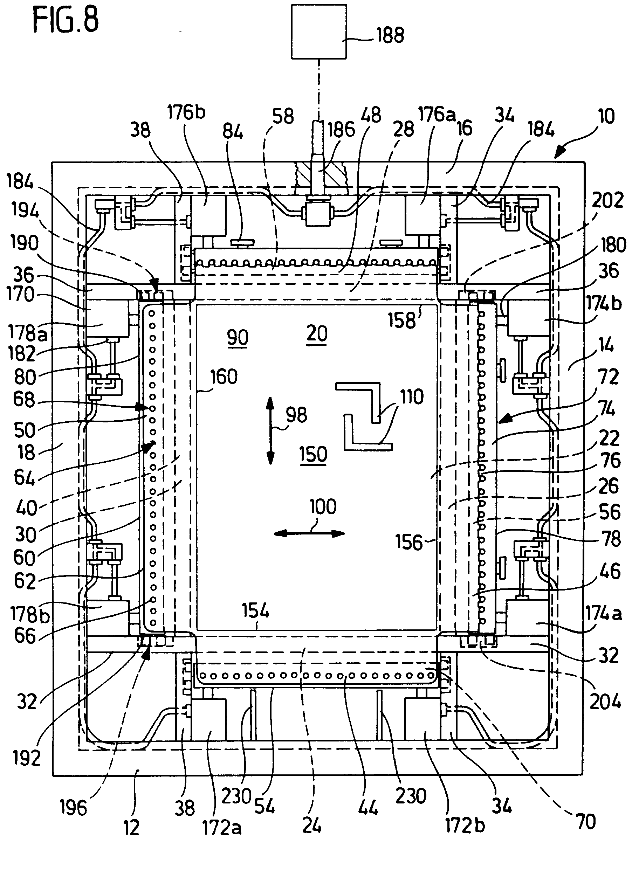

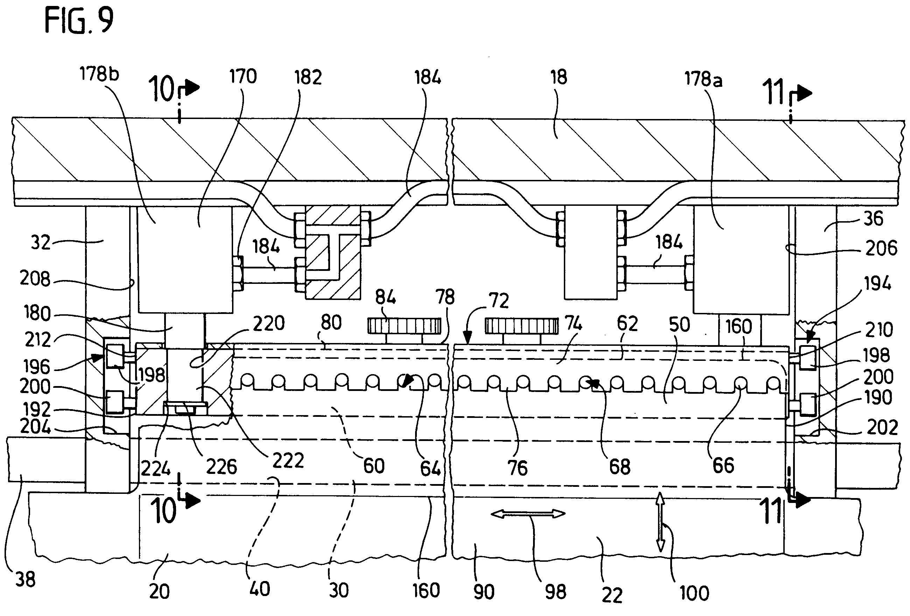

Bei dem zweiten Ausführungsbeispiel des erfindungsgemäßen Schablonenhalters, dargestellt in Fig. 8 und 9, wirken zwischen den Rahmenträgern 12, 14, 16 und 18 und den Haltestegen 54, 56, 58, 60 jeweils paarweise an dem jeweiligen Rahmenträger 12, 14, 16, 18 mit ihrem Zylindergehäuse 170 angeordnete Spannzylinder 172a,b, 174a,b, 176a,b und 178a,b, wobei eine Kolbenstange 180 der Zylinder 172, 174, 176, 178 mit dem jeweiligen Haltesteg 54, 56, 58, 60 verbunden ist.

Ein Druckanschluß 182 von jedem der Zylinder 172, 174, 176, 178 ist mit einer am Rahmen 10 geführten Druckleitung 184 verbunden, wobei die Druckleitung 184 mittig über einen Druckanschlußstutzen 186 mit einer Druckquelle 188 verbindbar ist, die ständig einen konstanten Druck liefert, der dazu führt, daß jeder der Spannzylinder 172, 174, 176, 178 mit derselben Kraft auf den jeweiligen Haltesteg 54, 56, 58, 60 wirkt, da die Druckleitung 184 in den parallel geschalteten Spannzylindern 172, 174, 176, 178 jeweils denselben Druck aufbaut.

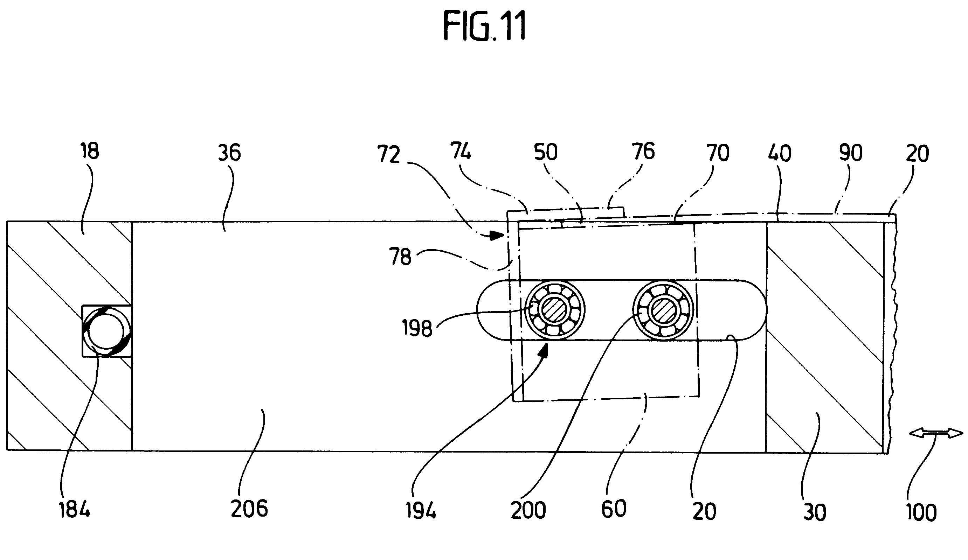

Im Gegensatz zum ersten Ausführungsbeispiel ist, wie in Fig. 9 und Fig. 11 dargestellt, jeder der Haltestege 54, 56, 58, 60 an seinen beiden Enden 190, 192 mit einem Rollenpaar 194, 196 zweier im Abstand voneinander angeordneter Laufrollen 198, 200 versehen, welche, wie in Fig. 9 und 11 am Beispiel des Haltestegs 60 dargestellt, in einer Nut 202, 204 der den Enden 190, 192 zugeordneten Stege 336, 32 geführt sind. Die Nuten 202, 204 sind dabei so dimensioniert, daß diese die Rollen 198, 200 exakt parallel zur jeweiligen Spannrichtung, im Fall der Fig. 9 und 11 der Spannrichtung 100, führen, so daß damit auch der jeweilige Haltesteg 60 eine zur Spannrichtung 100 parallele Führung erfährt.

Quer zur Spannrichtung 100 ist in dem in Fig. 9 dargestellten Ausführungsbeispiel der jeweilige Haltesteg 60 dadurch geführt, daß dessen Enden 190, 192 an der jeweils zugewandten Strebe 36, 32 auf deren dem Haltesteg 60 zugewandter Oberfläche 206, 208 mit seiner Endfläche 210, 212 gleitet. Eine noch präzisere Führung des jeweiligen Haltestegs 58 quer zur Spannrichtung 98 ist noch dadurch möglich, daß zwischen den Enden 190, 192 des jeweiligen Haltestegs 60 und den Streben 36, 32 des Rahmens 10 eine Wälzkörperführung wirksam ist, über die sich dann die Enden 190, 192 des jeweiligen Haltestegs 60 an den jeweils endseitig angeordneten Endstreben 32, 36 abstützen.

Die Verbindung zwischen der Kolbenstange 180 eines jeden der Spannzylinder 172, 174, 176, 178 erfolgt durch eine in dem jeweiligen Haltesteg 58 angeordnete Bohrung 220, welche ein endseitiger, im Durchmesser reduzierter Abschnitt 222 der Kolbenstange 180 durchgreift, wobei dieser an seinem Ende mit einer radial überstehenden und einen Ringflansch 224 im jeweiligen Haltesteg übergreifenden Scheibe 226 versehen ist, welche die Zugkraft des jeweiligen Spannzylinders 176 auf den jeweiligen Haltesteg 58 über den Ringflansch 224 einwirken läßt.

Um eine besonders exakte Positionierung der Haltestege 54, 56, 58, 60 im gespannten Zustand der Schablone 20 zu erhalten, ist vorzugsweise jeweils einem von zwei paarweise einander gegenüberliegenden Haltestegen 54, 58 oder 56, 60 ein Endanschlag, in Form zweier Endanschlagelemente 230 zugeordnet, welche es erlauben, eine Endposition des jeweiligen Haltestegs 54, 56 bei eine Zugwirkung auf alle Haltestege 54, 56, 58, 60 entfaltenden Spannzylindern 172, 174, 176, 178 exakt festzulegen, so daß der jeweils gegenüberliegende Haltesteg 58, 60 aufgrund der auf diesen wirkenden Spannzylinder 176, 178 die Schablone ausgehend von diesen Endstellungen gespannt hält, während die Spannzylinder 172, 174 den jeweiligen Haltesteg 54, 56 an den Anschlagstiften 230 anliegend halten. Damit ist durch die Anschlagelemente 230 die Möglichkeit geschaffen, die Schablone 20 mit noch größerer Präzision als durch die Längsführungen der Haltestege 54, 56, 58, 60 möglich, zu positionieren.

Bei einer Variante des zweiten Ausführungsbeispiels ist es aber ebenfalls denkbar, die Haltestege 54, 56, 58, 60 nicht nur parallel zu der jeweiligen Spannrichtung 98, 100 zu führen, in welcher sie wirksam sind, sondern auch vorzusehen, daß jedes Paar von in einer der Spannrichtungen 98 oder 100 wirksamen Haltestegen 54, 58 bzw. 56, 60 in der jeweils anderen Spannrichtung 100 bzw. 98 zumindest begrenzt bewegbar ist. Zu diesem Zweck ist, wie am Beispiel des Haltestegs 60 in Fig. 9 dargestellt, der jeweilige Haltesteg 60 dadurch geführt, daß dessen Enden 190, 192 mit Spiel zwischen der jeweils zugewandten Strebe 36, 32 geführt sind, so daß die Endflächen 210, 212 des Haltestegs 60 nach begrenzter Bewegung in Richtung der ersten Spannrichtung 98 jeweils an den diesen zugewandten Oberflächen 206, 208 der Streben 36, 32 zur Anlage kommen, während der jeweilige Haltesteg 60 in seiner Spannrichtung 100 wirksam und in dieser auch durch die in den Nuten 202, 204 liegenden Laufrollen 198, 200 beweglich gegenüber dem Rahmen 10 geführt ist.

Mit dieser Variante des zweiten Ausführungsbeispiels ist zwar keine exakte Positionierung der Schablone 20 beim Spannen mehr möglich, es ist jedoch die Möglichkeit gegeben, durch eine Markierung auf der Schablone den Spannrahmen für den Siebdruckvorgang durch die Einrichtungen zum Bewegen des Spannrahmens exakt so zu positionieren, daß die Durchbrüche 110 in der gewünschten Position liegen.

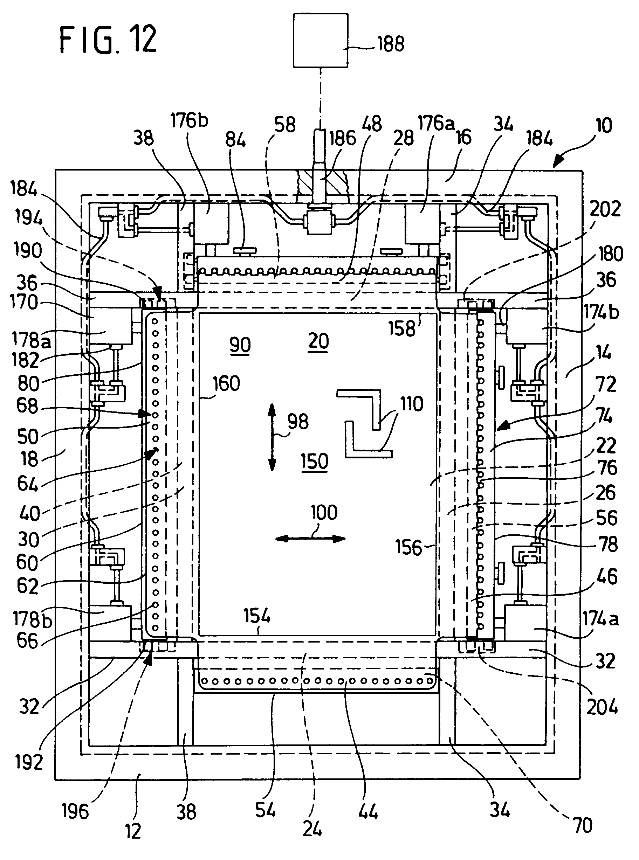

Bei einem dritten Ausführungsbeispiel eines erfindungsgemäßen Schablonenhalters, dargestellt in Fig. 12, ist einer der Haltestege 54, 56, 58, 60, beispielsweise der Haltesteg 54, sowohl in seiner wirksamen Spannrichtung 98 sowie auch quer zu dieser, das heißt parallel zur Spannrichtung 100, unverschieblich am Rahmen 10 fixiert.

Die übrigen Haltestege 56, 58, 60 sind sowohl in ihrer wirksamen Spannrichtung, das heißt im Fall des Haltestegs 58 in der ersten Spannrichtung 98 und im Fall der Haltestege 56 und 60 in Richtung der Spannrichtung 100, bewegbar gelagert, vorzugsweise aber auch ebenso quer zu ihrer wirksamen Spannrichtung, das heißt beim Haltesteg 58 in Spannrichtung 100 und bei den Haltestegen 56 und 60 in Spannrichtung 98, wobei die Haltestege 56, 58, 60 vorzugsweise in dieser Richtung mit Spiel geführt sind, wie im Zusammenhang mit der Variante des zweiten Ausführungsbeispiels beschrieben.

Ferner sind die Haltestege 56, 58, 60 noch durch die Spannzylinder 174, 176 und 178 in der beschriebenen Weise beaufschlagbar, um die Schablone 20 zu spannen.

Bei dem dritten Ausführungsbeispiel gemäß Fig. 12 ist nun, obwohl der Haltesteg 54 fest an den Stegen 38 und 34 gehalten ist, beim Beaufschlagen der Spannzylinder 174, 176 und 178 die Möglichkeit eines gleichmäßigen Spannens der Schablone 20 in beiden Spannrichtungen 98, 100 dadurch gegeben, daß die Haltestege 56, 60 die Möglichkeit haben, sich quer zu ihrer wirksamen Spannrichtung 100, das heißt also in Spannrichtung 98, zwischen den Stegen 36 und 32 mit Spiel zu bewegen und somit eine geringfügige Deformation der ausgehend von dem festen Haltesteg 54 gespannten Schablone 20 auszugleichen. Darüber hinaus hat vorteilhafterweise auch der Haltesteg 58 die Möglichkeit, sich quer zu seiner wirksamen Spannrichtung 98, das heißt in Spannrichtung 100, zwischen den Stegen 38 und 34 mit Spiel zu bewegen, um eventuell durch das Spannen der Haltestege 56, 60 mit den Spannzylindern 174 und 178 auftretende Querbewegungen, also Bewegungen in Richtung der Spannrichtung 100, auszugleichen.

Hinsichtlich der Beschreibung der übrigen Merkmale des dritten Ausführungsbeispiels wird vollinhaltlich auf die Ausführungen zum ersten und zweiten Ausführungsbeispiel Bezug genommen.

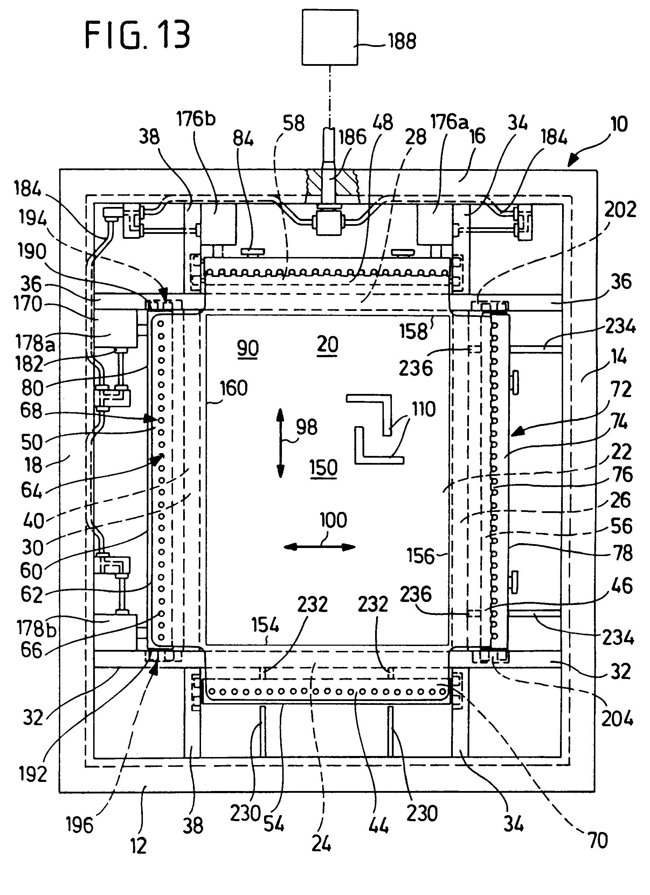

Bei einem vierten Ausführungsbeispiel, dargestellt in Fig. 13, sind sowohl der Haltesteg 54 als auch der Haltesteg 56 nicht mehr von einem Spannzylinder beaufschlagt, sondern diese sind in ihrer wirksamen Spannrichtung 98 bzw. 100 zwischen Endanschlägen 230 und 232 bzw. 234 und 236 fixiert.

Quer zu ihrer jeweils wirksamen Spannrichtung, das heißt im Fall des Haltestegs 54 in Spannrichtung 100 und im Fall des Haltestegs 58 in Spannrichtung 98, sind die Haltestege 54 und 56 mit Spiel zwischen den jeweiligen Streben 38 und 34 oder 32 und 36 gelagert, wobei vorzugsweise die Fixierung der Haltestege 54 und 56 in gleicher Weise wie im Zusammenhang mit dem zweiten Ausführungsbeispiel beschrieben, also über Nuten 202 und 204 in den entsprechenden Stegen 38 und 34 bzw. 32 und 36 sowie an den Enden der Haltestege 54 und 56 angeordneten Laufrollenpaaren 194, 196, erfolgt.

Die anderen beiden Haltestege 58 und 60 sind in der bereits beschriebenen Art und Weise gelagert und durch Spannzylinder 176 bzw. 178 in der jeweiligen wirksamen Spannrichtung 98 bzw. 100 beaufschlagbar.

Zusätzlich sind auch die Haltestege 58 und 60 quer zu ihrer wirksamen Spannrichtung, das heißt im Fall des Haltestegs 58 in Spannrichtung 100 und im Fall des Haltestegs 60 in Spannrichtung 98, zwischen den jeweiligen Stegen 34 und 38 bzw. 36 und 32 mit Spiel bewegbar angeordnet.

Bei einer Druckbeaufschlagung der Spannzylinder 176 und 178 wirken nun die entsprechenden Haltestege 58 bzw. 60 in der jeweiligen Spannrichtung 98 bzw. 100 und gleichzeitig haben alle Haltestege 54, 56, 58 und 60 die Möglichkeit, durch die Verschiebbarkeit quer zur wirksamen Spannrichtung zwischen den entsprechenden Stegen sich soweit zu verschieben, daß die Schablone 20 gleichmäßig in beiden Spannrichtungen 98, 100 spannbar ist.

Hinsichtlich der Beschreibung der übrigen Merkmale des vierten Ausführungsbeispiels wird vollinhaltlich auf die Ausführungen zum ersten und zweiten Ausführungsbeispiel Bezug genommen.

## Patentansprüche

1. Schablonennalter vorzugsweise zum Siebdruck, umfassend eine Schablone (20) mit sich im Anschluß an einen Schablonenbereich (150) erstreckenden Haltestreifen (44, 46, 48, 50), welche sich maximal über die jeweilige Länge eines Randes (154, 156, 158, 160) des Schablonenbereichs (150) in der jeweiligen Längsrichtung desselben erstrecken, einen Rahmen (10), an dem Rahmen angeordnete, die Haltestreifen (44, 46, 48, 50) der Schablone (20) haltende Schablonenaufnahmen (54, 56, 58, 60), von denen zwei einander gegenüberliegen und in einer ersten Spannrichtung (98) ein Spannen der Schablone (20) bewirken und zwei einander gegenüberliegen und in einer zweiten Spannrichtung (100) ein Spannen der Schablone (20) bewirken, wobei jeder Haltestreifen (44, 46, 48, 50) an jeweils einer einzigen Schablonenaufnahme (54, 56, 58, 60) durch Öffnungen (64) in den Haltestreifen (44, 46, 48, 50) durchgreifende Halteelemente (68) mit Formschluß lösbar fixierbar ist, und eine Schablonenspanneinrichtung,
**dadurch gekennzeichnet,** daß der Schablonenbereich (150) und die Haltestreifen (44, 46, 48, 50) der Schablone (20) aus einer einstückigen Metallfolie sind,
daß die Schablonenspanneinrichtung zum Spannen der Schablone (20) eine erste Spannkraftquelle (122; 172, 176) aufweist, welche auf mindestens eine der in der ersten Spannrichtung spannenden Schablonenaufnahmen (54, 58) mit einer Spannkraft wirkt und diese in der ersten Spannrichtung (98) bewegt und eine zweite Spannkraftquelle (122; 174, 178) aufweist, welche auf mindestens eine der in der zweiten Spannrichtung spannenden Schablonenaufnahmen (56, 60) mit einer Spannkraft wirkt und diese in der zweiten Spannrichtung (100) bewegt,
und daß die Schablonenaufnahmen (54, 56, 58, 60) derart angeordnet sind, daß sie bei wirksamen Spannkräften die Schablone (20) in einem zwischen dem Schablonenbereich (150) und dem Angriff der Schablonenaufnahmen (54, 56, 58, 60) liegenden Bereich gegen fest an dem Rahmen (10) gehaltene Auflagestege (24, 26, 28, 30) ziehen.

2. Schablonennalter nach Anspruch 1, dadurch gekennzeichnet, daß die Schablonenaufnahmen zwei einander gegenüberliegende Haltestege (54, 58) aufweisen, die an dem Rahmen (10) ausschließlich in Richtung der ersten Spannrichtung (98) verschieblich geführt sind, daß die erste Spannkraftquelle (122; 172, 176) auf die beiden Haltestege (54, 58) gleichzeitig mit derselben Spannkraft wirkt, daß die Schablonenaufnahmen zwei weitere einander gegenüberliegende Haltestege (56, 60) aufweisen, die am Rahmen (10) ausschließlich in Richtung der zweiten Spannrichtung (100) verschleblich geführt sind, und daß die zweite Spannkraftquelle (122; 174, 178) auf diese beiden Haltestege (56, 60) gleichzeitig mit derselben Spannkraft wirkt.

3. Schablonenhalter nach Anspruch 2, dadurch gekennzeichnet daß die erste Spannkraftquelle und die zweite Spannkraftquelle eine gemeinsame Spannkraftquelle (122, 134) ist, die auf alle Haltestege (54, 56, 58, 60) wirkt.

4. Schablonennalter nach Anspruch 1, dadurch gekennzeichnet, daß die Schablonenaufnahmen zwei wirksame, einander gegenüberliegende Haltestege (54) aufweisen, von denen einer fest mit dem Rahmen (10) verbunden ist, und der dem festen Haltesteg (54) gegenüberliegende Haltesteg (58) in der ersten Spannrichtung (98) gegenüber dem Rahmen (10) bewegbar ist und daß die Schablonenaufnahmen in der zweiten Spannrichtung (100) wirksame Haltestege (56, 60) aufweisen, die in der ersten Spannrichtung (98) gegenüber dem Rahmen (10) bewegbar sind und mindestens einer der in der zweiten Spannrichtung (100) wirksamen Haltestege (56, 60) in der zweiten Spannrichtung (100) gegenüber dem Rahmen (10) bewegbar ist.

5. Schablonenhalter nach Anspruch 4, dadurch gekennzeichnet, daß der in der ersten Spannrichtung (98) wirksame und in dieser bewegbare Haltesteg (58) auch in der zweiten Spannrichtung (100) gegenüber dem Rahmen (10) bewegbar ist.

6. Schablonenhalter nach Anspruch 1, dadurch gekennzeichnet, daß die Schablonenaufnahmen zwei in der ersten Spannrichtung (98) wirksame Haltestege (54, 58) aufweisen, von denen mindestens einer in der ersten Spann richtung (98) gegenüber dem Rahmen (10) bewegbar gelagert ist, daß beide in der ersten Spannrichtung wirksamen Haltestege (54, 58) in der zweiten Spannrichtung verschieblich sind und daß die Schablonenaufnahmen in der zweiten Spannrichtung (100) wirksame Haltestege (56, 60) aufweisen, die in der ersten Spannrichtung (98) gegenüber dem Rahmen (10) bewegbar sind und daß mindestens einer der in der zweiten Spannrichtung (100) wirksamen Haltestege (56, 60) in der zweiten Spannrichtung (100) gegenüber dem Rahmen (10) bewegbar ist.

7. Schablonennalter nach einem der Ansprüche 4 bis 6, dadurch gekennzeichnet, daß beide in der zweiten Spannrichtung (100) wirksamen Haltestege (56, 60) in dieser bewegbar gegenüber dem Rahmen (10) gelagert sind.

8. Schablonenhalter nach Anspruch 6 oder 7, dadurch gekennzeichnet, daß einer der Haltestege (54) in der ersten Spannrichtung (98) unverschieblich an dem Rahmen (10) gelagert ist.

9. Schablonenhalter nach Anspruch 6 oder 7, dadurch gekennzeichnet, daß beide in der ersten Spannrichtung (98) wirksamen Haltestege (54, 58) in dieser bewegbar gegenüber dem Rahmen (10) gelagert sind.

10. Schablonenhalter nach einem der voranstehenden Ansprüche, dadurch gekennzeichnet, daß die bewegbaren Haltestege (54, 56, 58, 60) durch eine Verschiebeführung (94, 96, 102) geführt sind.

11. Schablonenhalter nach Anspruch 10, dadurch gekennzeichnet, daß die Haltestege (54, 56, 58, 60) an einer in der jeweiligen Spannrichtung (98, 100) wirksamen Parallelführung (94, 96, 102) gelagert sind.

12. Schablonenhalter nach einem der voranstehenden Ansprüche, dadurch gekennzeichnet, daß die in der jeweiligen Spannrichtung (98, 100) wirksamen Spannkraftquellen (122; 172, 174, 176, 178) derart miteinander gekoppelt sind, daß auf die Haltestege (54, 56, 58, 60) gleichzeitig dieselben Spannkräfte wirken.

13. Schablonenhalter nach einem der voranstehenden Ansprüche, dadurch gekennzeichnet, daß die Schablonenspanneinrichtung mindestens einen zwischen dem jeweiligen Haltesteg (54, 56, 58, 60) und dem Rahmen (10) wirkenden Spannzylinder (172, 174, 176, 178) umfaßt.

14. Schablonenhalter nach Anspruch 13, dadurch gekennzeichnet, daß die Spannzylinder (172, 174, 176, 178) parallel geschaltet und mit einer Druckleitung (184) verbunden sind.

15. Schablonenhalter nach Anspruch 14, dadurch gekennzeichnet, daß zwischen dem jeweiligen Haltesteg (54, 56, 58, 60) und dem Rahmen (10) jeweils zwei parallel wirkende Spannzylinder (172a, b, 174a, b, 176a, b, 178a, b) vorgesehen sind.

16. Schablonenhalter nach Anspruch 15, dadurch gekennzeichnet, daß die Spannzylinder (172, 174, 176, 178) bei gespannter Schablone (20) ständig mit einem unter Druck stehenden Medium beaufschlagt sind.

17. Schablonenhalter nach einem der Ansprüche 1 bis 12, dadurch gekennzeichnet, daß die Spanneinrichtung einen Spannzug (122) und ein Spannelement (134) umfaßt.

18. Schablonenhalter nach Anspruch 17, dadurch gekennzeichnet, daß der Spannzug (122) jeweils eine zwischen dem Rahmen (10) und dem jeweiligen Haltesteg (54, 56, 58, 60) wirksame Schleife (124) bildet.

19. Schablonenhalter nach einem der voranstehenden Ansprüche, dadurch gekennzeichnet, daß die Fixierung der Schablone in der Schablonenaufnahme durch Öffnungen (64) in den Haltestreifen (44, 46, 48, 50) und die Öffnungen (64) durchgreifende Halteelemente (68) erfolgt.

20. Schablonenhalter nach einem der voranstehenden Ansprüche, dadurch gekennzeichnet, daß jede Schablonenaufnahme (54, 56, 58, 60) eine quer zur Spannrichtung (98, 100) wirksame Positioniereinrichtung (64, 68) aufweist.

21. Schablonenhalter nach Anspruch 20, dadurch gekennzeichnet, daß die Positioniereinrichtung eine Passung (64, 68) umfaßt.

22. Schablonenhalter nach Anspruch 21, dadurch gekennzeichnet, daß die Passung durch eine Lochreihe (64) gebildet ist, in welche entsprechende Passfinger (68) eingreifen.

23. Schablonenhalter nach einem der voranstehenden Ansprüche, dadurch gekennzeichnet, daß in jeder Spannrichtung (98, 100) zwei einander gegenüberliegende Haltestege (56, 60; 54, 58), welche am Rahmen (10) gelagert sind, die Schablonenaufnahmen bilden.

24. Schablonenhalter nach Anspruch 23, dadurch gekennzeichnet, daß in einer am jeweiligen Haltesteg (54, 56, 58, 60) fixierten Stellung jeder Haltestreifen (44, 46, 48, 50) mit einem Niederhalter (72) auf einer Fixierauflagefläche (70) des jeweiligen Haltestegs (54, 56, 58, 60) aufliegend gehalten ist.

25. Schablonenhalter nach Anspruch 24, dadurch gekennzeichnet, daß der Niederhalter (72) in der fixierenden Stellung den jeweiligen Haltestreifen (44, 46, 48, 50) in Bereichen zwischen den als Fixierzapfen (66) ausgebildeten Halteelementen (68) mit Fingern (76) übergreift.

26. Schablonenhalter nach einem der voranstehenden Ansprüche, dadurch gekennzeichnet, daß die Schablonenaufnahmen (54, 56, 58, 60) auf einer der Schablone (20) gegenüberliegenden Seite einer durch die Auflagestege (24, 26, 28, 30) definierten Ebene (52) angeordnet sind.

27. Schablonenhalter nach einem der voranstehenden Ansprüche, dadurch gekennzeichnet, daß dieser einen aus Rahmenträgern (12, 14, 16, 18) gebildeten äußeren Rahmen (10) aufweist, in welchem ein Schablonenfeld (22) angeordnet ist und daß das Schablonenfeld (22) durch vier Auflagestege (24, 26, 28, 30) begrenzt ist, welche über Streben (32, 34, 36, 38) mit dem äußeren Rahmen (10) verbunden sind.

28. Schablonenhalter nach einem der voranstehenden Ansprüche, dadurch gekennzeichnet, daß jeder der Auflagestege (24, 26, 28, 30) eine Auflagefläche (40) aufweist, auf welcher die Haltestreifen (44, 46, 48, 50) der Schablone (20) auflegbar sind.

29. Schablonenhalter nach einem der voranstehenden Ansprüche, dadurch gekennzeichnet, daß sich jeder Haltestreifen (44, 46, 48, 50) über den jeweiligen Auflagesteg (24, 26, 28, 30) hinaus bis zu dem jeweiligen Haltesteg (54, 56, 58, 60) erstreckt.

## Claims

1. Stencil holder preferably for screen printing, comprising a stencil (20) having holding strips (44, 46, 48, 50) extending on from a stencil region (150), said holding strips extending at the most over the respective length of an edge (154, 156, 158, 160) of the stencil region (150) in the respective longitudinal direction thereof, a frame (10), stencil receiving means (54, 56, 58, 60) arranged on the frame and holding the holding strips (44, 46, 48, 50) of the stencil (20), two of said stencil receiving means being located opposite one another and effecting in a first tensioning direction (98) a tensioning of the stencil (20), and two of said stencil receiving means being located opposite one another and effecting in a second tensioning direction (100) a tensioning of the stencil (20), each holding strip (44, 46, 48, 50) being adapted to be detachably secured by positive connection on a single stencil receiving means (54, 56, 58, 60) by holding elements (68) penetrating apertures (64) in the holding strips (44, 46, 48, 50), and a stencil tensioning device, **characterized** in that the stencil region (150) and the holding strips (44, 46, 48, 50) of the stencil (20) are made from a one-piece metal film, that the stencil tensioning device has a first source (122; 172, 176) of tensioning force for tensioning the stencil (20), said first source of tensioning force acting with a tensioning force on at least one of the stencil receiving means (54, 58) tensioning in the first tensioning direction and moving it in the first tensioning direction (98), and a second source (122; 174, 178) of tensioning force acting with a tensioning force on at least one of the stencil receiving means (56, 60) tensioning in the second tensioning direction and moving it in the second tensioning direction (100), and that the stencil receiving means (54, 56, 58, 60) are arranged such that they pull with operative tensioning forces the stencil (20) in a region located between the stencil region (150) and the engagement of the stencil receiving means (54, 56, 58, 60) against supporting webs (24, 26, 28, 30) held firmly on the frame (10).

2. Stencil holder as defined in claim 1, characterized in that the stencil receiving means have two oppositely located holding webs (54, 58) guided on the frame (10) for displacement exclusively in the direction of the first tensioning direction (98), that the first source (122; 172, 176) of tensioning force acts on the two holding webs (54, 58) at the same time with the same tensioning force, that the stencil receiving means have two further oppositely located holding webs (56, 60) guided on the frame (10) for displacement exclusively in the direction of the second tensioning direction (100), and that the second source (122; 174, 178) of tensioning force acts on these two holding webs (56, 60) at the same time with the same tensioning force.

3. Stencil holder as defined in claim 2, characterized in that the first source of tensioning force and the second source of tensioning force are a common source (122, 134) of tensioning force which acts on all holding webs (54, 56, 58, 60).

4. Stencil holder as defined in claim 1, characterized in that the stencil receiving means have two operative, oppositely located holding webs (54), one of which is fixedly connected to the frame (10), and the holding web (58) located opposite the fixed holding web (54) is movable in the first tensioning direction (98) in relation to the frame (10), and that the stencil receiving means have holding webs (56, 60) operative in the second tensioning direction (100) which are movable in the first tensioning direction (98) in relation to the frame (10), and at least one of the holding webs (56, 60) operative in the second tensioning direction (100) is movable in the second tensioning direction (100) in relation to the frame (10).

5. Stencil holder as defined in claim 4, characterized in that the holding web (58) operative in the first in the first tensioning direction (98) and movable in this direction is also movable in the second tensioning direction (100) in relation to the frame (10).

6. Stencil holder as defined in claim 1, characterized in that the stencil receiving means have two holding webs (54, 58) operative in the first tensioning direction (98), at least one of which is mounted for movement in the first tensioning direction (98) in relation to the frame (10), that both holding webs (54, 58) operative in the first tensioning direction are displaceable in the second tensioning direction, and that the stencil receiving means have holding webs (56, 60) operative in the second tensioning direction (100) which are movable in the first tensioning direction (98) in relation to the frame (10), and that at least one of the holding webs (56, 60) operative in the second tensioning direction (100) is movable in the second tensioning direction (100) in relation to the frame (10).

7. Stencil holder as defined in any one of claims 4 to 6, characterized in that both holding webs (56, 60) operative in the second tensioning direction (100) are mounted for movement in this direction in relation to the frame (10).

8. Stencil holder as defined in claim 6 or 7, characterized in that one of the holding webs (54) is mounted on the frame (10) so as to be non-displaceable in the first tensioning direction (98).

9. Stencil holder as defined in claim 6 or 7, characterized in that both holding webs (54, 58) operative in the first tensioning direction (98) are mounted for movement in this direction in relation to the frame (10).

10. Stencil holder as defined in any one of the preceding claims, characterized in that the movable holding webs (54, 56, 58, 60) are guided by a displacement guide (94, 96, 102).

11. Stencil holder as defined in claim 10, characterized in that the holding webs (54, 56, 58, 60) are mounted on a parallel guide (94, 96, 102) operative in the respective tensioning direction (98, 100).

12. Stencil holder as defined in any one of the preceding claims, characterized in that the sources (122; 172, 174, 176, 178) of the tensioning force operative in the respective tensioning direction (98, 100) are coupled with one another such that the same tensioning forces act on the holding webs (54, 56, 58, 60) at the same time.

13. Stencil holder as defined in any one of the preceding claims, characterized in that the stencil tensioning device comprises at least one tension cylinder (172, 174, 176, 178) acting between the respective holding web (54, 56, 58, 60) and the frame (10).

14. Stencil holder as defined in claim 13, characterized in that the tension cylinders (172, 174, 176, 178) are joined in parallel and connected to one pressure line (184).

15. Stencil holder as defined in claim 14, characterized in that two tension cylinders (172a, b, 174a, b, 176a, b, 178a, b) acting in parallel are provided between each respective holding web (54, 56, 58, 60) and the frame (10).

16. Stencil holder as defined in claim 15, characterized in that the tension cylinders (172, 174, 176, 178) are constantly acted upon with a medium under pressure when the stencil (20) is tensioned.

17. Stencil holder as defined in any one of claims 1 to 12, characterized in that the tensioning device comprises a tension pulley (122) and a tensioning element (134).

18. Stencil holder as defined in claim 17, characterized in that the tension pulley (122) forms a loop (124) operative between the frame (10) and each respective holding web (54, 56, 58, 60).

19. Stencil holder as defined in any one of the preceding claims, characterized in that the stencil is secured in the stencil receiving means by means of apertures (64) in the holding strips (44, 46, 48, 50) and holding elements (68) penetrating the apertures (64).

20. Stencil holder as defined in any one of the preceding claims, characterized in that each stencil receiving means (54, 56, 58, 60) has a positioning means (64, 68) operative transversely to the tensioning direction (98, 100).

21. Stencil holder as defined in claim 20, characterized in that the positioning means comprises a fit (64, 68).

22. Stencil holder as defined in claim 21, characterized in that the fit is formed by a row of holes (64) and corresponding fitting fingers (68) engaging therein.

23. Stencil holder as defined in any one of the preceding claims, characterized in that two oppositely located holding webs (56, 60; 54, 58) mounted on the frame (10) form the stencil receiving means in each tensioning direction (98, 100).

24. Stencil holder as defined in claim 23, characterized in that in a position secured on the respective holding web (54, 56, 58, 60) each holding strip (44, 46, 48, 50) is held by a holding-down device (72) so as to rest on a securing support surface (70) of the respective holding web (54, 56, 58, 60).

25. Stencil holder as defined in claim 24, characterized in that in the securing position the holding-down device (72) engages with fingers (76) over the respective holding strip (44, 46, 48, 50) in regions between the holding elements (68) designed as securing pins (66).

26. Stencil holder as defined in any one of the preceding claims, characterized in that the stencil receiving means (54, 56, 58, 60) are arranged on a side located opposite the stencil (20) of a plane (52) defined by the supporting webs (24, 26, 28, 30).

27. Stencil holder as defined in any one of the preceding claims, characterized in that this has an outer frame (10) formed by frame supports (12, 14, 16, 18), a stencil section (22) being arranged in said frame, and that the stencil section (22) is limited by four supporting webs (24, 26, 28, 30) connected with the outer frame (10) via struts (32, 34, 36, 38).

28. Stencil holder as defined in any one of the preceding claims, characterized in that each of the supporting webs (24, 26, 28, 30) has a support surface (40), the holding strips (44, 46, 48, 50) of the stencil (20) being adapted to rest on said surface.

29. Stencil holder as defined in any one of the preceding claims, characterized in that each holding strip (44, 46, 48, 50) extends beyond the respective supporting web (24, 26, 28, 30) as far as the respective holding web (54, 56, 58, 60).

## Revendications

1. Support de trame, de préférence pour de la sérigraphie, comprenant une trame (20) comportant des bandes de retenue (44, 46, 48, 50) qui s'étendent à la suite d'une zone de trame (150) et qui s'étendent au maximum sur la longueur respective d'un bord (154, 156, 158, 160) de la zone de trame (150) dans la direction longitudinale respective de celle-ci, un cadre (10), des logements de trame (50, 56, 58, 60) agencés sur le cadre et retenant les bandes de retenue (44, 46, 48, 50) de la trame (20) et dont deux sont opposés l'un à l'autre et provoquent une tension de la trame (20) dans une première direction de tension (98) et dont deux sont opposés l'un à l'autre et provoquent une tension de la trame (20) dans une seconde direction de tension (100), chaque bande de retenue (44, 46, 48, 50) pouvant être fixée de façon détachable par une liaison par la forme à un logement de trame unique (54, 56, 58, 60) respectif par des éléments de retenue (68) qui traversent des ouvertures (64) dans les bandes de retenue (44, 46, 48, 50), et un dispositif de tension de trame,
*caractérisé* en ce que la zone de trame (150) et les bandes de retenue (44, 46, 48, 50) de la trame (20) sont constituées d'une feuille métallique d'une pièce,
en ce que le dispositif de tension de trame présente pour la tension de trame (20) une première source de force de tension (122; 172, 176) qui agit avec une force de tension sur au moins un des logements de trame (54, 58) tendant dans la première direction de tension et qui déplace celui-ci dans la première direction de tension (98), et présente une seconde source de force de tension (122; 174, 178) qui agit avec une force de tension sur au moins un des logements de trame (56, 60) tendant dans la seconde direction de tension et qui déplace celui-ci dans la seconde direction de tension (100), et
en ce que les logements de trame (54, 56, 58, 60) sont agencés de façon à ce que, lors de forces de tension actives, ils tirent la trame (20) dans une zone située entre la zone de trame (150) et la prise des logements de trame (54, 56, 58, 60), contre des traverses d'appui (24, 26, 28, 30) retenues fixement sur le cadre (10).

2. Support de trame suivant la revendication 1, caractérisé en ce que les logements de trame présentent deux traverses de retenue (54, 58) opposées l'une à l'autre et qui sont guidées de façon mobile sur le cadre (10), exclusivement dans la direction de la première direction de tension (98), en ce que la première source de force de tension (122; 172, 176) agit simultanément avec la même force de tension sur les deux traverses de retenue (54, 58), en ce que les logements de trame présentent deux autres traverses de retenue (56, 60) opposées l'une à l'autre et qui sont guidées de façon mobile sur le cadre (10), exclusivement dans la direction de la seconde direction de tension (100), et en ce que la seconde source de force de tension (122; 174, 178) agit simultanément avec la même force de tension sur ces deux traverses de retenue (56, 60).

3. Support de trame suivant la revendication 2, caractérisé en ce que la première source de force de tension et la seconde source de force de tension sont une source de force de tension commune (122, 134) qui agit sur toutes les traverses de retenue (54, 56, 58, 60).

4. Support de trame suivant la revendication 1, caractérisé en ce que les logements de trame présentent deux traverses de retenue (54) actives opposées l'une à l'autre et dont l'une est reliée fixement au cadre (10) et dont la traverse de retenue (58) opposée à la traverse de retenue fixe (54) est mobile dans la première direction de tension (98) par rapport au cadre (10) et en ce que les logements de trame présentent des traverses de retenue (56, 60) agissant dans la seconde direction de tension (100), qui sont mobiles dans la première direction de tension (98) par rapport au cadre (10) et en ce qu'au moins une des traverses de retenue (56, 60) agissant dans la seconde direction de tension (100) est mobile dans la seconde direction de tension (100) par rapport au cadre (10).

5. Support de trame suivant la revendication 4, caractérisé en ce que la traverse de retenue (58) agissant dans la première direction de tension (98) et mobile dans celle-ci est mobile également dans la seconde direction de tension (100) par rapport au cadre (10).

6. Support de trame suivant la revendication 1, caractérisé en ce que les logements de trame présentent deux traverses de retenue (54, 58) agissant dans la première direction de tension (98) et dont au moins une est montée de façon mobile dans la première direction de tension (98) par rapport au cadre (10), en ce que les deux traverses de retenue (54, 58) agissant dans la première direction de tension sont mobiles dans la seconde direction de tension et en ce que les logements de trame présentent des traverses de retenue (56, 60) agissant dans la seconde direction de tension (100) et qui sont mobiles dans la première direction de tension (98) par rapport au cadre (10) et en ce qu'au moins une des traverses de retenue (56, 60) agissant dans la seconde direction de tension (100) est mobile dans la seconde direction de tension (100) par rapport au cadre (10).

7. Support de trame suivant l'une des revendications 4 à 6, caractérisé en ce que les deux traverses de retenue (56, 60) agissant dans la seconde direction de tension (100) sont montés de façon mobile dans celle-ci par rapport au cadre (10).

8. Support de trame suivant la revendication 6 ou 7, caractérisé en ce qu'une des traverses de retenue (54) est montée de façon immobile dans la première direction de tension (98) sur le cadre (10).

9. Support de trame suivant la revendication 6 ou 7, caractérisé en ce que les deux traverses de retenue (54, 58) agissant dans la première direction de tension (98) sont montées de façon mobile dans celle-ci par rapport au cadre (10).

10. Support de trame suivant l'une des revendications précédentes, caractérisé en ce que les traverses de retenue mobiles (54, 56, 58, 60) sont guidées par un guidage coulissant (94, 96, 102).

11. Support de trame suivant la revendication 10, caractérisé en ce que les traverses de retenue (54, 56, 58, 60) sont montées sur un guidage paralléle (94, 96, 102) agissant dans la direction de tension (98, 100) respective.

12. Support de trame suivant l'une des revendications précédentes, caractérisé en ce que les sources de force de tension (122; 172, 174, 176, 178) agissant dans la direction de tension (98, 100) respective sont raccordées l'une à l'autre de façon à ce que les mêmes forces de tension agissent simultanément sur les traverses de retenue (54, 56, 58, 60).

13. Support de trame suivant l'une des revendications précédentes, caractérisé en ce que dispositif de tension de trame comprend au moins un cylindre de tension (172, 174, 176, 178) agissant entre la traverse de retenue (54, 56, 58, 60) respective et le cadre (10).

14. Support de trame suivant la revendication 13, caractérisé en ce que les cylindres de tension (172, 174, 176, 178) sont branchés en paralléle et sont reliés à une conduite de pression (184).

15. Support de trame suivant la revendication 14, caractérisé en ce que chaque fois deux cylindres de tension (172a, b, 174a, b, 176a, b, 178a, b) agissant en parallèle sont prévus entre la traverse de retenue (54, 56, 58, 60) respective et le cadre (10).

16. Support de trame suivant la revendication 15, caractérisé en ce que les cylindres de tension (172, 174, 176, 178) sont alimentés constamment par un milieu sous pression lorsque la trame (20) est tendue.

17. Support de trame suivant l'une des revendications 1 à 12, caractérisé en ce que le dispositif de tension comprend un cordon de tension (122) et une élément de tension (134).

18. Support de trame suivant la revendication 17, caractérisé en ce que le cordon de tension (122) forme chaque fois une boucle (124) agissant entre le cadre (10) et la traverse de retenue (54, 56, 58, 60) respective.

19. Support de trame suivant l'une des revendications précédentes, caractérisé en ce que la fixation de la trame dans les logements de trame est effectuée par des ouvertures (64) dans les bandes de retenue (44, 46, 48, 50) et par des éléments de retenue (68) traversant les ouvertures (64).

20. Support de trame suivant l'une des revendications précédentes, caractérisé en ce que chaque logement de trame (54, 56, 58, 60) présente un dispositif de positionnement (64, 68) agissant transversalement à la direction de tension (98, 100).

21. Support de trame suivant la revendication 20, caractérisé en ce que le dispositif de positionnement comprend un ajustage (64, 68).

22. Support de trame suivant la revendication 21, caractérisé en ce que l'ajustage est formé par une série de trous (64) dans lesquels pénètrent des salles d'ajustage (68) correspondantes.

23. Support de trame suivant l'une des revendications précédentes, caractérisé en ce que dans chaque direction de tension (98, 1000), deux traverses de retenue (56, 60; 54, 58) opposées l'une à l'autre et qui sont montées sur le cadre (10) forment les logements de trame.

24. Support de trame suivant la revendication 23, caractérisé en ce que, dans une position fixée sur la traverse de retenue (54, 56, 58, 60) respective, chaque bande de retenue (44, 46, 48, 50) est retenue appliquée par un serre-flan (72) sur une surface d'appui de fixation (70) de la traverse de retenue (54, 56, 58, 60) respective.

25. Support de trame suivant la revendication 24, caractérisé en ce que le serre-flan (72) déborde par des saillies (76), dans la position de fixation, la bande de retenue (44, 46, 48, 50) respective dans des zones entre les éléments de retenue (68) réalisés sous la forme de broches de fixation (66).

26. Support de trame suivant l'une des revendications précédentes, caractérisé en ce que les logements de trame (54, 56, 58, 60) sont agencés sur un côté, opposé à la trame (20), d'un plan (52) déterminé par les traverses d'appui (24, 26, 28, 30).

27. Support de trame suivant l'une des revendications précédentes, caractérisé en ce que celui-ci présente un cadre (10) externe qui est formé par des supports de cadre (12, 14, 16, 18) et dans lequel est agencé un champ d'opération de trame (22) et en ce que le champ d'opération de trame (22) est délimité par quatre traverses d'appui (24, 26, 28, 30) qui sont reliées par des entretoises (32, 34, 36, 38) au cadre externe (10).

28. Support de trame suivant l'une des revendications précédentes, caractérisé en ce que chacune des traverses d'appui (24, 26, 28, 30) présente une face d'appui (40) sur laquelle peuvent être appliquées les bandes de retenue (44, 46, 48, 50) de la trame (20).

29. Support de trame suivant l'une des revendications précédentes, caractérisé en ce que chaque bande de retenue (44, 46, 48, 50) s'étend au-delà de la traverse d'appui (24, 26, 28, 30) respective, jusqu'à la traverse de retenue (54, 56, 58, 60) respective.
